# EUROPEAN PATENT SPECIFICATION

(11) **EP 2 774 263 B1**
(45) Date of publication and mention of the grant of the patent: **18.10.2017**
(21) Application number: 12846494.8
(22) Date of filing: 31.10.2012
(51) Int. Cl.: H02S 99/00, H01L 31/042

(54) **CELL-TO-GRID REDUNDANT PHOTOVOLTAIC SYSTEM**
REDUNDANTE ZELLE-ZU-NETZ-FOTOVOLTAIKANLAGE
SYSTÈME PHOTOVOLTAÏQUE REDONDANT CELLULE SUR GRILLE

(30) Priority: 31.10.2011 US 201161553822 P; 02.11.2011 US 201161554710 P; 12.01.2012 US 201261585720 P; 26.01.2012 US 201261590925 P; 05.04.2012 US 201261620566 P; 29.08.2012 US 201261694548 P; 29.08.2012 US 201261694559 P; 11.09.2012 US 201261699701 P
(43) Date of publication of application: 10.09.2014
(73) Proprietor: Tenksolar, Inc., Minneapolis, MN 55431 (US)
(72) Inventor: MEYER, Dallas, W., Prior Lake, MN 55372 (US); BERG, Lowell, Eden Prairie, MN 55347 (US); NOVOTNY, John, Eden Prairie, MN 55347 (US); GROSS, Shady, Bloomington, Minnesota 55431 (US); MEYER, Forrest, C., Eden Prairie, MN 55346 (US)
(74) Representative: Maikowski & Ninnemann Patentanwälte Partnerschaft mbB
(86) International application number: PCT/US2012/062784
(87) International publication number: WO 2013/066998

(56) References cited:
- WO-A1-2010/068226
- KR-A- 20100 129 721
- US-A1- 2007 179 720
- US-A1- 2008 164 766
- US-A1- 2009 183 760
- US-A1- 2009 217 965
- US-A1- 2010 219 688
- US-A1- 2010 253 151
- US-A1- 2010 282 293
- US-A1- 2011 018 353
- US-A1- 2011 241 431

## Description

### FIELD

Example embodiments described herein relate to photovoltaic (PV) systems with multiple redundant paths from individual PV cells to an electrical power grid.

### BACKGROUND

In a conventional photovoltaic array, most, if not all, connections used starting at the cell level and continuing out to the grid connection are single-point-of-failure. Any failed connection anywhere in the system results in a complete failure and an unscheduled service call. Several new topologies have been developed to at least separate the individual modules from each other; however, these topologies are also made up of single-point-of-failure devices, and given the added quantity required, minimal to no improvement in reliability is expected.

US 2010/282293 A1 discloses a plurality of discrete photovoltaic cells arranged in a plurality of cell rows, and a substantially electrically conductive and continuous area backsheet forming a current return path.

Further, US 2009/183760 A1 discloses a photovoltaic module comprising a conductive backsheet.

The subject matter claimed herein is not limited to embodiments that solve any disadvantages or that operate only in environments such as those described above. Rather, this background is only provided to illustrate one exemplary technology area where some embodiments described herein may be practiced.

### SUMMARY

According to the invention, a photovoltaic system is provided, the system comprising:
a plurality of photovoltaic modules, each photovoltaic module defining a first end and a second end opposite the first end, wherein each photovoltaic module comprises:
   a plurality of photovoltaic cells, wherein energy generated by each photovoltaic cell has multiple paths through the plurality of photovoltaic cells to the second end; and
   a plurality of converters electrically coupled to the plurality of photovoltaic cells at the second end such that energy generated by each photovoltaic cell is receivable at any of the plurality of converters;
a continuous backsheet, the continuous backsheet comprising a ground plane for the plurality of photovoltaic cells;
wherein the continuous backsheet is electrically coupled between a first subset of the plurality of photovoltaic cells at the first end and a second subset of the plurality of photovoltaic cells at the second end, wherein the continuous backsheet is configured to carry module return current from the second end to the first end;
a first end connection between the continuous backsheet and the first subset of the plurality of photovoltaic cells at the first end;
a second end connection between the plurality of converters and the second subset of the plurality of photovoltaic cells at the second end;
a circuit card mechanically coupled to the second end, the circuit card including the plurality of converters disposed thereon and further including a positive connector and a negative connector;
an internal bus strip extending along a width of the photovoltaic module, wherein the internal bus strip is coupled to each of the photovoltaic cells in the second subset of the plurality of photovoltaic cells; and
a module-to-module bus electrically coupled to each of the plurality of photovoltaic modules, the module-to-module bus having an output, wherein energy generated by each photovoltaic module is receivable at the output independent of any other of the plurality of photovoltaic modules,
wherein one or more tabs extend from the continuous backsheet to one of the connectors of the circuit card, the one or more tabs electrically coupling the continuous backsheet to that one of the connectors of the circuit card,
   +
wherein the internal bus strip includes a tab extending from the internal bus strip through a slot or a cutout formed in the continuous backsheet to the other one of the connectors of the circuit card, the tab electrically coupling the internal bus strip to that one of the connectors of the circuit card.

Additional features and advantages of the invention will be set forth in the description which follows, and in part will be obvious from the description, or may be learned by the practice of the invention. The features and advantages of the invention may be realized and obtained by means of the instruments and combinations particularly pointed out in the appended claims. These and other features of the present invention will become more fully apparent from the following description and appended claims, or may be learned by the practice of the invention as set forth hereinafter.

### BRIEF DESCRIPTION OF THE DRAWINGS

To further clarify the above and other advantages and features of the present invention, a more particular description of the invention will be rendered by reference to specific embodiments thereof which are illustrated in the appended drawings. It is appreciated that these drawings depict only typical embodiments of the invention and are therefore not to be considered limiting of its scope. The invention will be described and explained with additional specificity and detail through the use of the accompanying drawings in which:
Figure 1 illustrates an example PV system according to some embodiments;
Figure 2 illustrates an example PV module that may be included in the PV system of Figure 1;
Figure 3A is a back view of an embodiment of a continuous backsheet included in the PV module of Figure 2;
Figure 3B is a back view of another embodiment of the continuous backsheet included in the PV module of Figure 2;

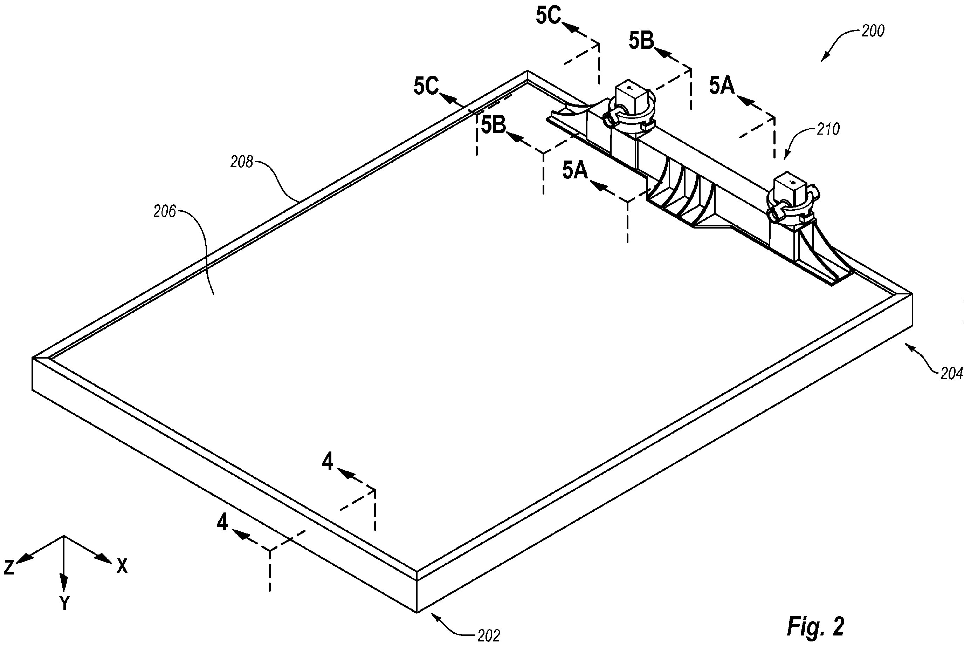

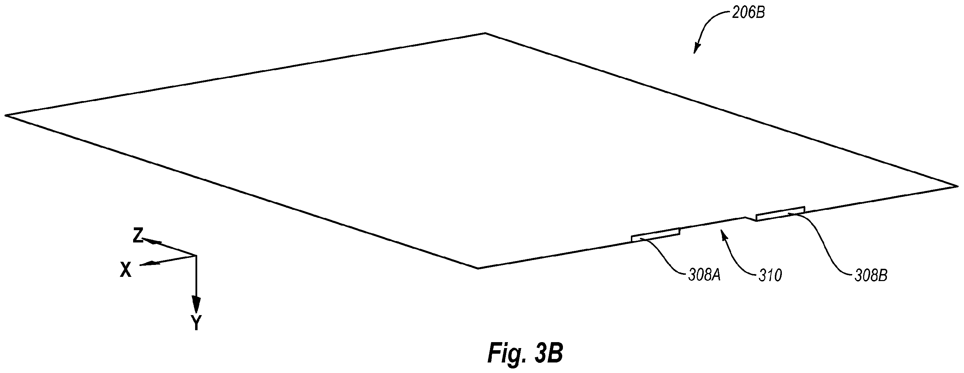

Figure 3B is a back view of another embodiment of the continuous backsheet included in the PV module of Figure 2;

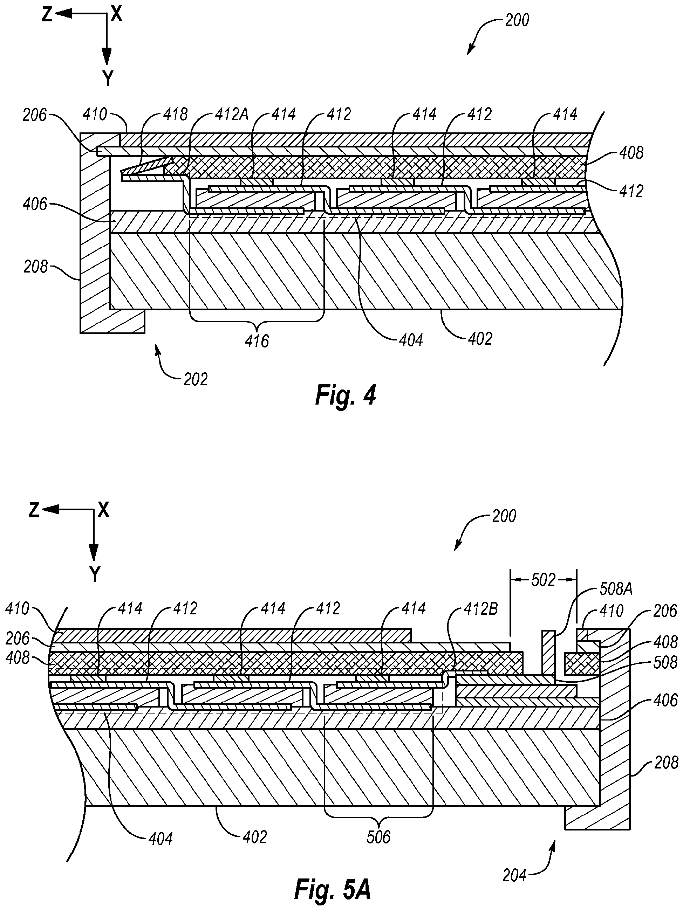

Figure 4 illustrates a cross-sectional view of a first end of the PV module of Figure 2;
Figures 5A-5C each illustrate a cross-sectional view of a second end of the PV module of Figure 2;

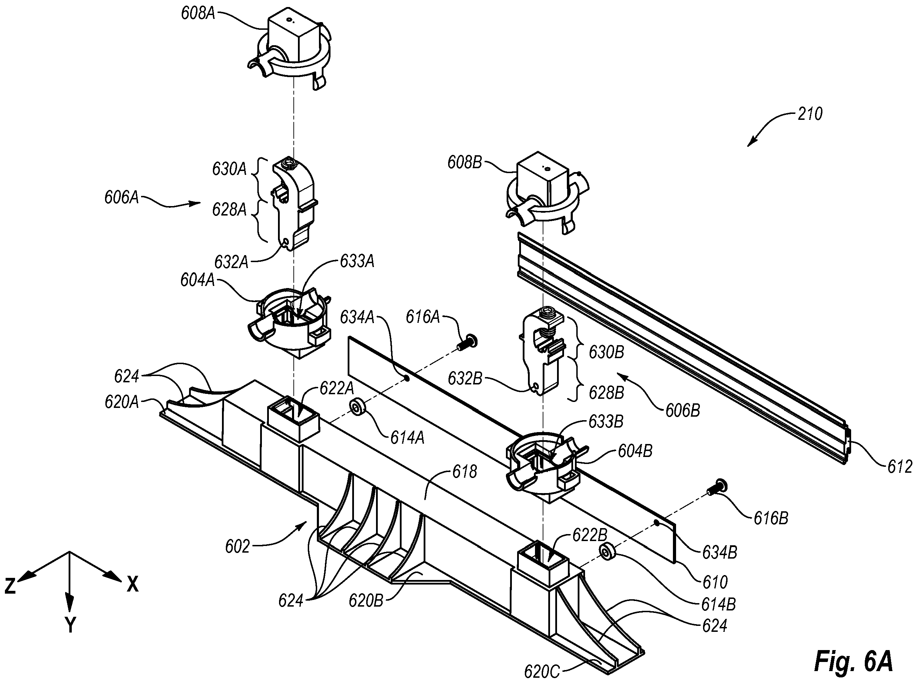

Figures 6A-6D illustrate an embodiment of an undermount assembly of the PV module of Figure 2;

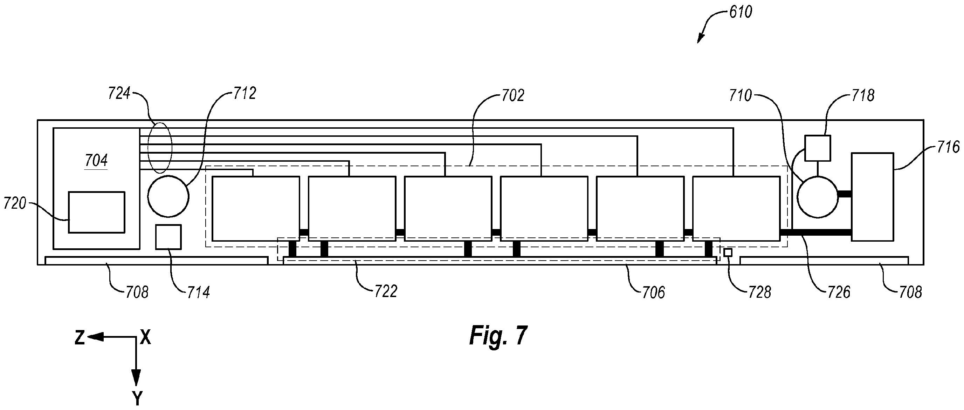

Figure 7 illustrates an example embodiment of a circuit card included in the undermount assembly of Figures 6A-6D;

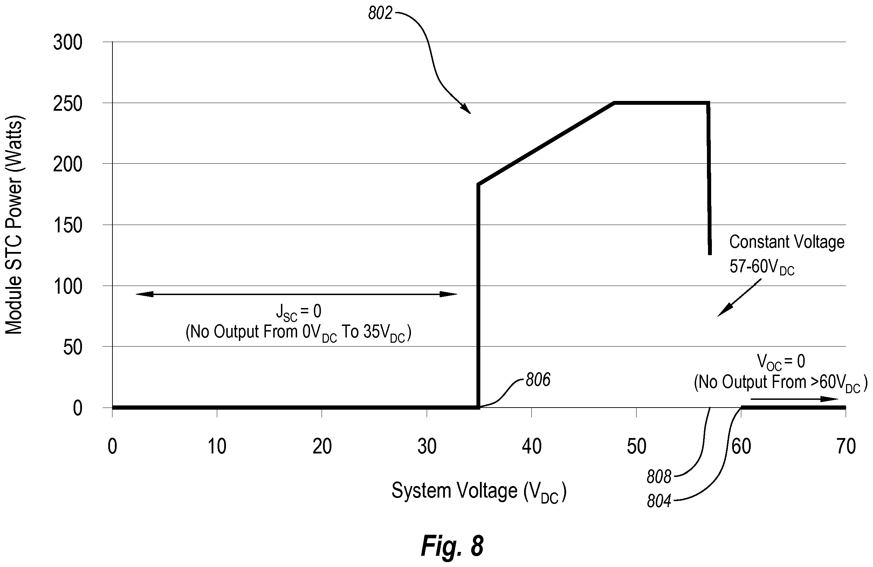

Figure 8 illustrates an example power/voltage curve for the PV module of Figure 2; and

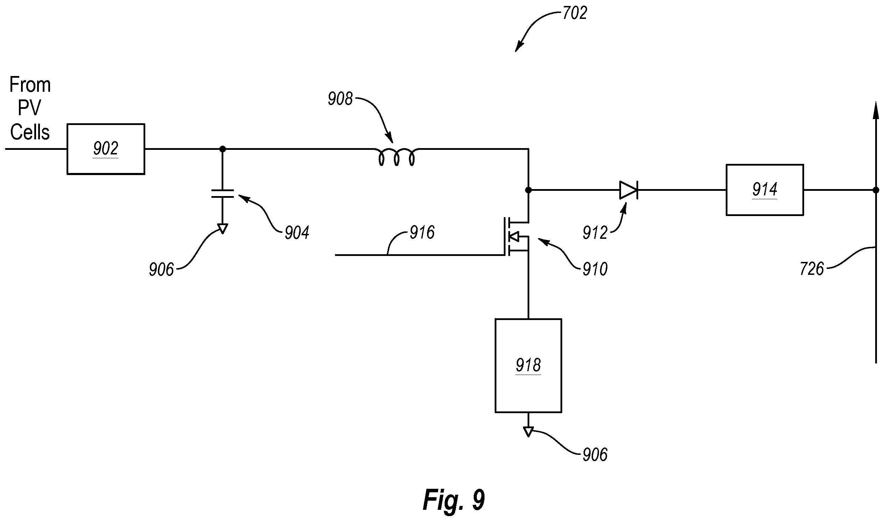

Figure 9 is a schematic diagram of an embodiment of a converter included on the circuit card of Figure 7.

### DETAILED DESCRIPTION OF SOME EXAMPLE EMBODIMENTS

Embodiments of the invention generally relate to a photovoltaic (PV) system supporting multiple redundant paths from individual PV cells to an electrical power grid. The redundancy provides fault tolerance in the PV system and may substantially reduce or eliminate maintenance requirements through the service life of the PV system compared to PV systems lacking such redundancy.

In more detail, an example PV system according to some embodiments is described where single-points-of-failure existing in some conventional PV systems have been replaced by connection points having various levels of redundancy. This allows for failure without stoppage of an entire PV module, and allows for either no repair-resulting in little to no energy lost-or at least a scheduled repair rather than an unscheduled repair.

In some embodiments described herein, all PV cells of a given PV module have some combination of parallel and serial connections such that current can take alternate paths through the PV module. A low impedance continuous backsheet is used across the rear of the PV module to allow for a single direction of current flow. Any failed interconnect or PV cell has minimum impact as the current can flow through an alternate route to converters included in the PV module.

The converters are interconnected to an internal bus strip within the PV module that allows any converter to see any cell, e.g., energy generated by a given cell can be received at any of the converters. Thus, some of the converters can fail without impacting energy production of the PV module. The converters output a fixed voltage direct current (DC) power to an output bus which is connected to a large cross-sectional area riser (or connector). The riser connects to a module-to-module bus without splicing the module-to-module bus such that the module-to-module bus remains continuous. As a result, each PV module is connected to the module-to-module bus independently of the others and a failure of one PV module will not affect the connections of other PV modules to the module-to-module bus.

The module-to-module bus is interconnected to multiple fixed voltage DC:AC conversion devices, or "inverters" herein. The inverters are connected to the electrical power grid and convert DC power on the module-to-module bus to AC power that is output to the electrical power grid. If some of the inverters fail, power can continue to flow through the other inverters. Accordingly, the entire PV system is cell-to-grid redundant as energy produced by each PV cell can take any one of multiple redundant paths to the electrical power grid.

Reference will now be made to the drawings to describe various aspects of example embodiments of the invention. It is to be understood that the drawings are diagrammatic and schematic representations of such example embodiments, and are not limiting of the present invention, nor are they necessarily drawn to scale.

### I. Example PV System

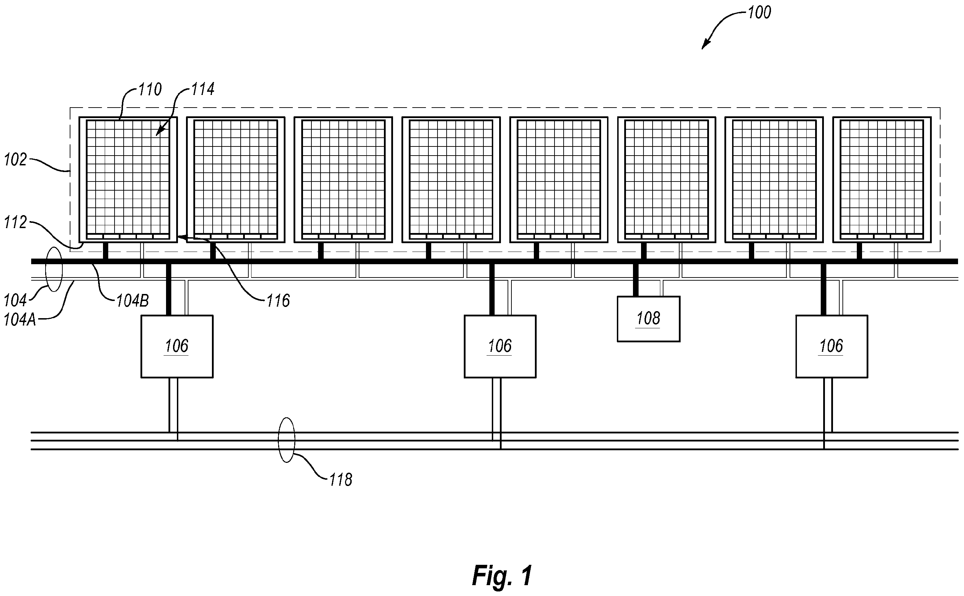

Figure 1 illustrates an example PV system 100, arranged in accordance with at least some embodiments described herein. The PV system 100 includes multiple PV modules or panels (hereinafter "modules") 102 and a module-to-module bus 104. Optionally, the PV system 100 additionally includes multiple inverters 106 and/or one or more energy storage devices 108.

An example configuration of each of the PV modules 102 will now be described. Although the specific aspects and features of the example configuration described herein are only called out in one of the PV modules 102 of Figure 1, it is understood that each of the PV modules 102 may be similarly configured.

As illustrated in Figure 1, each of the PV modules 102 defines a first end 110 and a second end 112. Each of the PV modules 102 includes multiple PV cells 114 electrically coupled together in a mesh such that energy, e.g., PV current, generated by each PV cell 114 has multiple paths through the PV cells 114 to the second end 112. In some embodiments, the mesh topology of the PV cells 114 is achieved by arranging the PV cells 114 in rows where the rows are coupled in series and the PV cells 114 in each row are coupled in parallel.

In some PV modules, the PV cells are electrically coupled in series such that an under-illuminated or poorly-performing or otherwise "blocked" PV cell limits the entire series. In embodiments described herein, however, because each PV cell 114 has multiple paths to the second end 112, when a PV cell 114 in one of the paths is blocked, energy produced by PV cells 114 upstream (e.g., nearer the first end 110) of the blocked PV cell 114 can flow around the blocked PV cell 114 through one of the other available paths.

Each of the PV modules 102 additionally includes multiple converter circuits (hereinafter "converters") 116 electrically coupled to the PV cells 114 at the second end 112 such that energy generated by each PV cell 114 is receivable at any of the converters 116. As such, if one of the converters 116 fails, the energy that was previously flowing to that converter 116 can flow to a different one of the converters 116. In general, the converters 116 are configured to convert relatively high-current, low-voltage energy collectively generated by the PV cells 114 to a lower current and higher voltage. Accordingly, each of the converters 116 may include, for example, a boost converter, a buck-boost converter, a SEPIC converter, a Ćuk converter, or the like or any combination thereof.

The module-to-module bus 104 is electrically coupled to each of the PV modules 102 such that the PV modules 102 are connected in parallel. The module-to-module bus 104 has at least one output and energy generated by each PV module 102 is receivable at the output independent of any other of the PV modules 102. In the illustrated embodiment, the module-to-module bus 104 has four outputs, including a different output coupled to each of the inverters 106 and to the energy storage device 108 such that energy on the module-to-module bus 104 can be output to any or all of the inverters 106 and/or to the energy storage device 108. The outputs of the module-to-module bus 104 can also function as inputs in some embodiments such that energy received through the inverters 106 and/or from the energy storage device 108 may be received on the module-to-module bus 104.

The module-to-module bus 104 is a DC bus for the DC output of the PV modules 102. In the illustrated embodiment, the module-to-module bus 104 includes a positive lead 104A and a negative lead 104B. Each of the positive lead 104A and the negative lead 104B may include a continuous and uninterrupted wire to which each of the PV modules 102 is electrically coupled. Because the leads 104A, 104B of the module-to-module bus 104 include continuous wires and the PV modules 102 are connected in parallel to the module-to-module bus 104, a failure of any one of the PV modules 102 will not affect an ability of any of the other PV modules 102 to output energy onto the module-to-module bus 104 to the inverters 106 and/or to the energy storage device 108. Accordingly, the PV system 100 can continue producing energy even in the event some of the PV modules 102 fail such that immediate maintenance on the failed PV modules 102 is not required to keep the PV system 100 running, as is the case with some PV systems where the PV modules or panels are connected in series.

The inverters 106 are electrically coupled to the module-to-module bus 104 such that energy generated by each of the PV modules 102 is receivable at any of the inverters 106. The inverters 106 each have a DC side, the DC sides of the inverters 106 being electrically coupled in parallel to the module-to-module bus 104. In general, the inverters 106 are configured to convert DC power on the module-to-module bus 104 to alternating current (AC) power that is output to an electrical power grid 118 (hereinafter "power grid 118") to which AC sides of the inverters 106 are coupled.

The inverters 106 may include fixed voltage inverters and the inverters 106 may control the voltage on the module-to-module bus 104. Alternately or additionally, the inverters 106 include reversible inverters such that when operated in reverse, the inverters 106 convert AC power from the power grid 118 to DC power that is output to the module-to-module bus 104 to charge the energy storage device 108, for example. Alternately or additionally, the inverters 106 are operated in a "fixed turn" configuration in which a ratio between the AC output voltage to the DC input voltage is fixed, causing the DC voltage to float with AC voltage fluctuations.

The power grid 118 may include a multiphase AC power grid, such as a three-phase AC power grid. The inverters 106 may be electrically coupled to any or all of the phases of the power grid 118. In the illustrated embodiment, each of the inverters 106 is electrically coupled to a different one of the three phases of the power grid 118 through, for example, a Wye or a Delta connection.

The energy storage device 108 may be coupled in parallel to the module-to-module bus 104.

In some embodiments, the inverters 106 have different DC setpoints. For example, the DC setpoints of the inverters 106 may be offset by 0.1-0.5 volts, or by less than 0.1 volts or more than 0.5 volts. In an example embodiment, one of the inverters 106 has a DC setpoint of 52.0 volts, another has a DC setpoint of 52.5 volts, and another has a DC setpoint of 53.0 volts. Where the inverters 106 have different DC setpoints, power distribution from the module-to-module bus 104 to the inverters 106 is determined by the DC setpoints. For example, the inverter 106 with the lowest DC setpoint, such as 52.0 volts, will begin pulling power when the voltage on the module-to-module bus 104 is 52.0 volts; if the voltage on the module-to-module bus 104 rises to the next DC setpoint, such as 52.5 volts, the inverter 106 with the next DC setpoint will then begin pulling power, and so on.

Alternately or additionally, the DC setpoints of the inverters 106 and/or AC curtailment of the inverters 106 may be adjustable. In general, AC curtailment is a limiting feature on the AC output from the inverter 106. In these and other embodiments, the inverters 106 may be communicatively coupled together, e.g., via a modbus, a controller area network (CAN) bus, or other communication channel. The inverters 106 may communicate with each other to coordinate control of inverter-specific settings such as the DC setpoints of the inverters 106, AC curtailment of the inverters 106, or other settings or limits.

By coupling each of the inverters 106 to a different phase of the power grid 118, implementing different DC setpoints for the inverters 106 and/or implementing adjustable DC setpoints for the inverters 106, the PV system 100 may be operated in a variety of ways. For example, current may selectively flow from the inverters 106 to different phases of the power grid 118, into the energy storage device 108 and/or from the energy storage device 108. As another example, current may flow from one or more phases of the power grid 118 to the module-to-module bus 104 via one or more of the inverters 106 with a relatively high DC setpoint and may flow along the module-to-module bus 104 with or without power generated by the PV modules 102 to one or more other phases of the power grid 118 via one or more of the inverters 106 with a relatively low DC setpoint. As another example, based on DC setpoints of the inverters 106 and a current state of charge of the energy storage device 108, current may flow into the energy storage device 108 from any or all phases of the power grid 118 or from the energy storage device 108 into any or all phases of the power grid 118.

Alternately or additionally, each of the inverters 106 may be selectively disabled and enabled based on one or more criteria. The criteria may be static or adjustable. The criteria may include voltage on the module-to-module bus 104, time of day, or other criteria. For example, one or more of the inverters 106 may be disabled every morning and/or evening when output of the PV modules 102 is expected to be relatively lower than at midday such that the remaining enabled inverters 106 operate at a relatively higher efficiency or the PV system 100 performance is otherwise optimized.

### II. PV Module

Figure 2 illustrates an example PV module 200 that may be included in the PV system 100 of Figure 1, arranged in accordance with at least some embodiments described herein. For example, the PV module 200 is an example embodiment of the PV modules 102 of Figure 1. The view in Figure 2 is an upside-down perspective view of the PV module 200. Figure 2 additionally includes arbitrarily-defined X, Y, and Z coordinate axes which are used throughout the various Figures to provide a consistent frame of reference. In the discussion that follows, a "top" or "front" of the PV module 200 (or subcomponent thereof) refers to the positive Y side of the PV module 200 (or subcomponent), while "bottom" or "back" refers to the negative Y side.

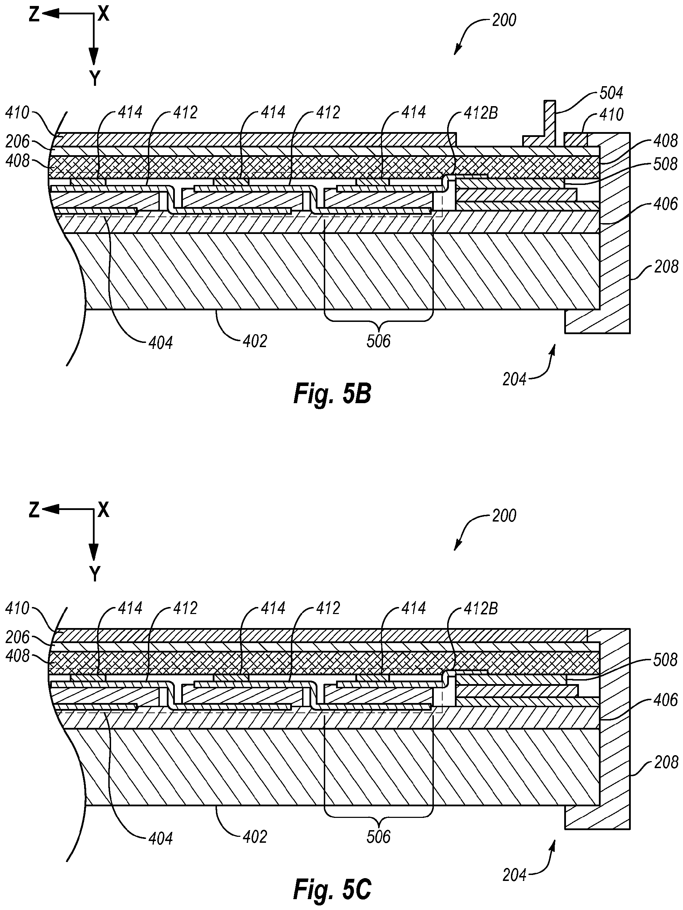

In the illustrated embodiment, the PV module 200 defines a first end 202 and a second end 204 corresponding to the first end 110 and the second end 112, respectively, of each of the PV modules 102 of Figure 1. The PV module 200 includes a continuous backsheet 206 and may optionally include a frame 208 around a perimeter of the continuous backsheet 206 and various layers of the PV module 200 (described in greater detail below with respect to Figures 4-5C). The PV module 200 additionally includes multiple PV cells (not shown in Figure 2) within the various layers of the PV module 200 and multiple converters (not shown in Figure 2). The multiple converters are included in an undermount assembly 210 mounted to the bottom of the PV module 200 at the second end 204 in the illustrated embodiment. Figure 2 additionally includes various cutting planes 4-4, 5A-5A, 5B-5B, and 5C-5C referenced in the discussions of Figures 4, 5A, 5B, and 5C below.

The continuous backsheet 206 in some embodiments generally extends from edge to edge of the PV module 200 and cooperates with the frame 208 and a transparent front plate (not shown) of the PV module 200 to enclose the PV cells (not shown) of the PV module 200 and protect against moisture ingress into the PV module 200. The continuous backsheet 206 may be between 0.025 to 0.4 millimeters (mm) thick and includes an electrically-conductive material such as, but not limited to, aluminum.

The continuous backsheet 206 may be a ground plane for the PV cells of the PV module 200. For example, the continuous backsheet 206 may be electrically coupled between a first subset of the PV cells (e.g., a first row of the PV cells as described with respect to Figure 4) at the first end 202 and a second subset of the PV cells (e.g., a last row of the PV cells as described with respect to Figures 5A-5C) at the second end. A first end connection (not shown) between the continuous backsheet 206 and the first subset of PV cells may be an anode of the PV module 200 as described in more detail below. A second end connection (not shown) between the multiple converters and the second subset of PV cells may be a cathode of the PV module 200 as described in more detail below. In these and other embodiments, module return current may be carried by the continuous backsheet 206 from the cathode to the anode of the PV module 200. III. Continuous Backsheet

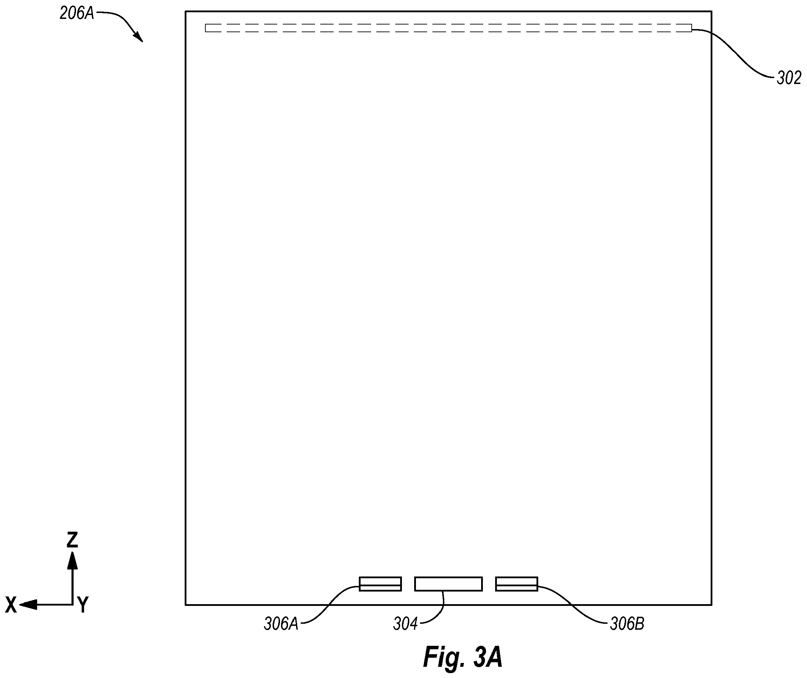

Figure 3A is a back view of an embodiment 206A of the continuous backsheet 206 of Figure 2, hereinafter "continuous backsheet 206A", arranged in accordance with at least some embodiments described herein. In the illustrated embodiment, the continuous backsheet 206A includes a ground strip 302 mechanically and electrically coupled to the continuous backsheet 206A at the first end 202 of the PV module 200.

The ground strip 302 may include copper, hot-dipped copper, tin-coated copper, or other electrically-conductive and solderable material. The ground strip 302 is ultrasonically welded to the continuous backsheet 206A in some embodiments. The ground strip 302 may have a thickness (e.g., in the Y direction) of about 100 micrometers (µm) and a width (e.g., in the Z direction) of about 10 mm.

The continuous backsheet 206A additionally defines a slot 304 and includes one or more tabs 306A, 306B (collectively "tabs 306"). The slot 304 in some embodiments has a width (e.g., a dimension in the Z direction) in a range from about 3 to 8 mm and a length (e.g., a dimension in the X direction) in a range from about 75 to 200 mm.

The tabs 306 in the illustrated embodiment include discrete tabs mechanically and electrically coupled to the continuous backsheet 206A. The tabs 306 may include copper, hot-dipped copper, tin-coated copper, or other electrically-conductive and solderable material. During assembly in some embodiments, a lengthwise edge of each of the tabs 306 is ultrasonically welded to the continuous backsheet 206A before the unwelded portion is bent to extend away from the continuous backsheet 206. The tabs 306 in some embodiments have a thickness (e.g., in the Y direction) of about 100 µm and a width (e.g., in the Z direction) before being bent of about 10 mm to about 14 mm.

Figure 3B is a back perspective view of an embodiment 206B of the continuous backsheet 206 of Figure 2, hereinafter "continuous backsheet 206B," arranged in accordance with at least some embodiments described herein. The continuous backsheet 206B is similar in some respects to the continuous backsheet 206A. For example, the continuous backsheet 206B may include a ground strip (not shown), such as the ground strip 302 of Figure 3A, mechanically and electrically coupled to the continuous backsheet 206B at the first end 202 of the PV module 200.

Similar to the continuous backsheet 206A, the continuous backsheet 206B additionally includes tabs 308A, 308B (collectively "tabs 308") that are similar in some respects to the tabs 306. For example, both of the tabs 306, 308 are located on the continuous backsheet 206A, 206B at the second end 204. Additionally, both of the tabs 306, 308 extend away from the continuous backsheet 206A, 206B in a plane substantially normal to a plane defined by the continuous backsheet 206A, 206B. However, the tabs 308 of Figure 3B are integral tabs integrally formed from the continuous backsheet 206B. Thus, the tabs 308 may include the same material(s) as the continuous backsheet 206B.

The continuous backsheet 206B additionally defines a cutout 310 rather than the slot 304 of Figure 3A.

Aspects of the slot 304, tabs 306, 308, cutout 310, and the PV module 200 of Figures 2-3B will now be explained with reference to Figures 4-5C. Figure 4 illustrates a cross-sectional view of the first end 202 of the PV module 200 at the cutting plane 4-4 of Figure 2, arranged in accordance with at least some embodiments described herein. Figures 5A-5C each illustrate a cross-sectional view of the second end 204 of the PV module 200 of Figure 2 at the respective cutting plane 5A-5A, 5B-5B, and 5C-5C of Figure 2, all arranged in accordance with at least some embodiments described herein. For simplicity, the undermount assembly 210 has been omitted from Figures 5A-5C.

With reference to Figure 4, the PV module 200 includes the continuous backsheet 206, the frame 208, a transparent front plate 402, and multiple rows of PV cells 404 sandwiched between the continuous backsheet 206 and the front plate 402. In the view of Figure 4, only one PV cell 404 in each of the rows of PV cells 404 is visible. The PV module 200 additionally includes an adhesive layer 406, a buffer layer 408, and an optional backskin 410.

The front plate 402 includes a substrate that is substantially transparent to at least some wavelengths of solar radiation. For example, the front plate 402 may include glass, plastic, or the like. The front plate 402 cooperates with the continuous backsheet 206 and the frame 208 to protect the PV cells 404 and other internal layers of the PV module 200 from moisture ingress.

The adhesive layer 406 mechanically couples the front plate 402 to the PV cells 404. The adhesive layer 406 may include ethylene-vinyl acetate (EVA), or other suitable adhesive. The adhesive layer 406 is substantially transparent to at least some wavelengths of solar radiation.

The buffer layer 408 mechanically couples the continuous backsheet 206 to the PV cells 404 and/or electrically insulates the PV cells 404 from the continuous backsheet 206. Thus, the buffer layer 408 may include an adhesive, an electrically-insulating material, or other suitable material, such as, but not limited to, EVA, polyethylene terephthalate (PET), or the like or any combination thereof.

The backskin 410 may include black PET or other material with a relatively high emissivity to facilitate cooling of the PV module 200. The backskin 410 may be slightly undersized compared to the continuous backsheet 206 along a perimeter of the backskin 410 to allow the frame 208 to wrap over the continuous backsheet 206 along its perimeter to allow edge sealing. Although not shown, an adhesive and/or sealant may be provided between the wrapped-over portion of the frame 208 and the continuous backsheet 206 along the perimeter of the continuous backsheet 206 for edge sealing.

Generally speaking, all of the PV cells 404 convert solar energy into electrical energy by the photovoltaic effect. The PV cells 404 may be p-type cells or n-type cells. In the discussion that follows, it is assumed that the PV cells 404 are p-type cells unless stated otherwise. Each of the PV cells 404 may have the same or substantially the same dimensions. In some embodiments, the dimensions of each of the PV cells 404 are one of: 156 mm by 156 mm, or 78 mm by 156 mm. Alternately, each of the PV cells 404 may have different dimensions than those listed. In some embodiments, the PV cells 404 are arranged in an array or rectangular pattern. For example, 156 mm by 156 mm PV cells 404 may be arranged in a 6x10 array (or rectangular pattern of 6x24 PV cells 404), a 6x12 array, or an 8x12 array. As another example, 78 mm by 156 mm PV cells may be arranged in a 6x 15 array, a 6x20 array, a 6x24 array, an 8x20 array, or an 8x24 array. The foregoing dimensions and array configurations are provided by way of example only and should not be construed to limit the invention.

The rows of PV cells 404 are electrically coupled in series by serial interconnects 412, including multiple serial interconnects 412 coupling each row of PV cells 404 to a corresponding adjacent row. For example, in some embodiments, at least one serial interconnect 412 couples a front side-or anode for p-type cells-of each PV cell 404 to a back side-or cathode for p-type cells-of a corresponding PV cell 404 in an adjacent row of PV cells 404 such that each PV cell 404 in a row has at least one direct electrical connection via a corresponding serial interconnect 412 to an adjacent row of PV cells 404.

The PV cells 404 in each row are electrically coupled together in parallel by conductive row strips 414. For example, the conductive row strip 414 running across the back of the right-most row of PV cells 404 in Figure 4 electrically couples back sides of each of the PV cells 404 in the right-most row together, while the conductive row strip 414 running across the back of the middle row of PV cells 404-together with the serial interconnects 412 from the front side of the right-most row to the back side of the middle row-electrically couples front sides of the PV cells 404 in the right-most row together such that the PV cells 404 in the right-most row are coupled together in parallel.

Each of the conductive row strips 414 may have a thickness (e.g., a dimension in the Y direction) in a range from about 25 µm to about 200 µm and a width (e.g., a dimension in the Z direction) in a range from about 2 mm to about 20 mm. Each of the conductive row strips 414 may have a same length (e.g., a dimension in the X direction) or about the same length as the corresponding row of PV cells 404.

As mentioned previously, energy generated by each PV cell 404 has multiple paths through the PV cells 404 to the second end 204 (not shown in Figure 4) of the PV module 200. The multiple paths through the PV cells 404 include the conductive row strips 414 and/or the serial interconnects 412 in some embodiments, such that generated current can flow, via the conductive row strips 414 and/or the serial interconnects 412, around blocked PV cells 404 and through PV cells 404 with relatively higher performance and/or higher illumination to the second end 204.

The rows of PV cells 404 include a first row 416 at the first end 202 of the PV module 200. As illustrated in Figure 4, serial interconnects 412A electrically and mechanically couple the first row 416 of PV cells 404 to a ground strip 418 such that the first row 416 of PV cells 404 is electrically coupled to the continuous backsheet 206. In some embodiments, at least one serial interconnect 412A couples a front side of each PV cell 404 in the first row 416 to the ground strip 418 such that each PV cell 404 in the first row 416 has at least one direct electrical connection via a corresponding serial interconnect 412A to the ground strip 418.

The ground strip 418 may correspond to the ground strip 302 of Figure 3A. Although illustrated in Figure 4 as being connected to the front side of the PV cells 404 in the first row 416, where the PV cells 404 are n-type cells, the ground strip 418 may instead be connected to the back side of the PV cells 404 in the first row 416 and other suitable modifications to the electrical connections described herein may be made.

The ground strip 418 and the serial interconnects 412A form the first end connection between the continuous backsheet 206 and the first row 416 of PV cells 404. The first end connection may be the anode of the PV module 200 in some embodiments. A reference voltage at the anode is zero volts since the anode is directly tied through the continuous backsheet 206 to a negative output of the PV module 200.

Reference is next made to Figures 5A-5C in which cross-sectional views of the second end 204 of the PV module 200 are illustrated. In Figures 5A-5C, the continuous backsheet 206 defines a slot 502 (Figure 5A) and includes tabs 504 (Figure 5B - only one tab 504 is visible). The slot 502 may correspond to the slot 304 of Figure 3A and the tabs 504 may correspond to the tabs 306 of Figure 3A. Thus, the continuous backsheet 206 illustrated in Figures 5A-5C includes the same configuration as the continuous backsheet 206A of Figure 3A. In other embodiments, however, the continuous backsheet 206 illustrated in Figures 5A-5C can include the same configuration as the continuous backsheet 206B of Figure 3B.

As illustrated in Figures 5A-5C, the rows of PV cells 404 include a last row 506 at the second end 204 of the PV module 200. Serial interconnects 412B electrically and mechanically couple the last row 506 of PV cells 404 to an internal bus strip 508. The internal bus strip 508 in some embodiments extends along a width (e.g., a dimension in the X direction) of the PV module 200. The internal bus strip 508 may include copper or other electrically-conductive material(s). In some embodiments, at least one serial interconnect 412B couples a back side-or cathode for p-type cells-of each PV cell 404 in the last row 506 to the internal bus strip 508 such that each PV cell 404 in the last row 506 has at least one direct electrical connection via a corresponding serial interconnect 412B to the internal bus strip 508.

Referring to Figure 5A, the internal bus strip 508 includes a tab 508A extending from the internal bus strip 508 through the slot 502 formed in the continuous backsheet 206 to a positive connector (not shown) of a circuit card (not shown) on which the converters are disposed. The circuit card is disposed within the undermount assembly 210 as described in more detail with respect to Figures 6A-6D below and is mechanically coupled to the second end 204 of the PV module 200. The tab 508A may be a discrete tab or an integral tab analogous to the discrete tabs and integral tabs described above with respect to Figures 3A-3B. Optionally, the tab 508A may include a stress-relief fold formed therein.

The serial interconnects 412B and the internal bus strip 508 form the second end connection between the converters and the last row 506 of PV cells 404. The second end connection may be the cathode of the PV module 200 in some embodiments.

In the illustrated embodiment, current generated by the PV cells 404 nominally flows through the PV cells 404 in a single direction from the first end 202, or anode, to the second end 204, or cathode of the PV module 200. As mentioned previously, however, current may at times flow laterally, e.g., orthogonal to the nominal flow direction, through the conductive row strips 414 to get around blocked PV cells 404. Return current for the PV module 200 flows through the continuous backsheet 206 in the opposite direction, e.g., from the second end 204, or cathode, to the first end 202, or anode.

Referring to Figure 5B, the tabs 504 extend from the continuous backsheet 206 to a negative connector (not shown) of the circuit card on which the converters are disposed. The tabs 504 electrically couple the continuous backsheet 206 to the negative connector of the circuit card, thereby grounding the circuit card to the continuous backsheet 206. As described with respect to the tabs 306 of Figure 3A, the tabs 504 may include copper or other electrically-conductive material that is also thermally conductive. Accordingly, the tabs 504 may facilitate thermal transfer of heat generated by the converters from the circuit card to the continuous backsheet 206 and frame 208 and out of the PV module 200. Optionally, the tabs 504 may each include a stress-relief fold formed therein. In some embodiments, the tabs 504 and the tab 508A are substantially aligned with each other, e.g., the tabs 504 and the tab 508A are substantially co-planar to simplify the soldering of the tabs 504, 508A to the corresponding connectors of the circuit card.

Referring to Figure 5C, a cross-sectional view of the second end 204 of the PV module 200 is provided cut through an area away from the tabs 508A (Figure 5A) and 504 (Figure 5B). As illustrated in Figures 4-5C, the continuous backsheet 206 extends all the way to the positive Z and negative Z edges of the PV module 200 to enhance sealing of the PV module 200 in cooperation with the frame 208 and the front plate 402. In a similar manner, the continuous backsheet 206 extends all the way to the positive X and negative X edges of the PV module 200.

### IV. Undermount Assembly

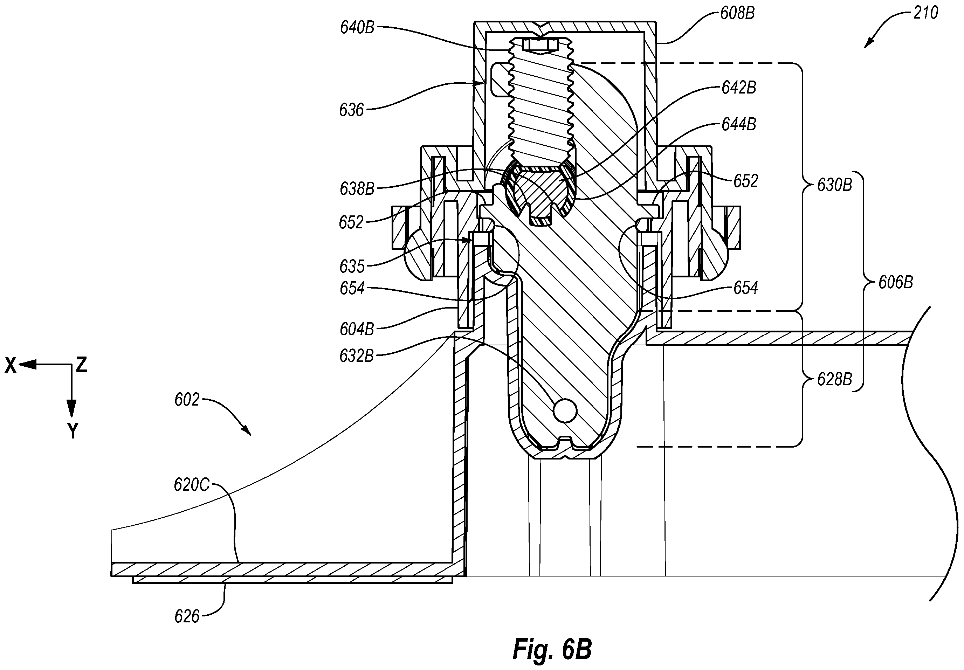

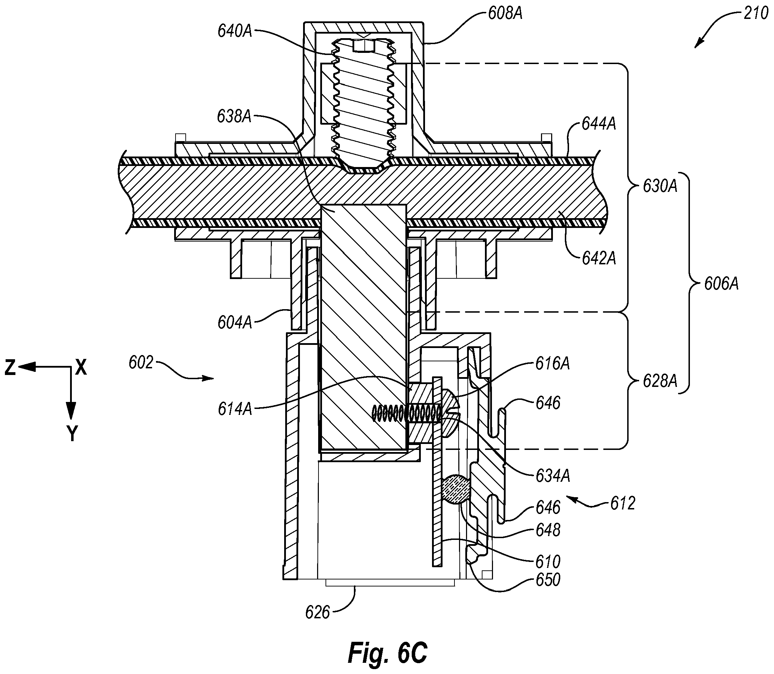

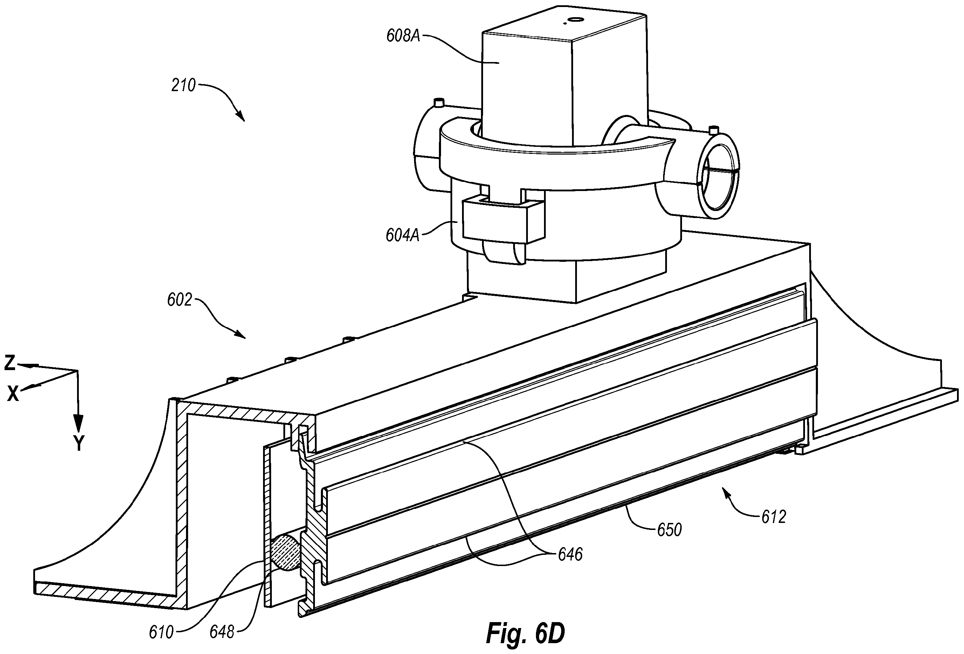

Figures 6A-6D illustrate an embodiment of the undermount assembly 210 of the PV module 200 of Figure 2, arranged in accordance with at least some embodiments described herein. In more detail, Figure 6A is an exploded view of the undermount assembly 210. Figure 6B is a cross-sectional view of a portion of the undermount assembly 210 in a plane parallel to the XY plane. Figure 6C is a cross-sectional view of the undermount assembly 210 in a plane parallel to the YZ plane. Figure 6D is a cross-sectional perspective view of the undermount assembly 210.

Referring to Figure 6A, the undermount assembly 210 includes a housing 602, two nests 604A, 604B (collectively "nests 604"), two risers 606A, 606B (collectively "risers 606"), two caps 608A, 608B (collectively "caps 608"), a circuit card 610, a cover 612, two washers 614A, 614B (collectively "washers 614"), and two screws 616A, 616B (collectively "screws 616").

The housing 602 includes an ultraviolet (UV) stabilized polymer such as, but not limited to, polymer, glass-filled polymer, mica-filled polymer, PET, polyoxymethylene (POM), or the like, including products sold by Dupont under the names Rynite and Delrin 527UV. The housing 602 includes a main body 618 and multiple feet 620A-620C (collectively "feet 620"). The main body 618 defines two slots 622A, 622B (collectively "slots 622"), aspects of which are described in more detail below.

The feet 620 extend from the main body 618 and are substantially coplanar in a plane parallel to the XZ plane. Each of the feet 620 includes one or more ribs or haunch stiffeners 624 to stabilize the main body 618 with respect to the feet 620. The undermount assembly 210 is mechanically coupled to the continuous backsheet 206 using an adhesive or tape 626 (Figure 6B) disposed between the continuous backsheet 206 and each of the feet 620. Optionally, a sealant is placed, as necessary, between the housing 602 and the continuous backsheet 206 to protect against moisture ingress.

The risers 606 include electrically-conductive material(s) such as, but not limited to, metal or metal alloys including aluminum, plated aluminum, copper, BeSn (Beryllium Tin)-coated copper, or the like or any combination thereof. Moreover, the risers 606 may be machined, extruded, or formed in some other manner. Each of the risers 606 includes a base 628A, 628B and a C-shaped end 630A, 630B opposite the base 628A, 628B. Each base 628A, 628B defines a tapped or self-tapping hole (hereafter "tapped hole") 632A, 632B.

The nests 604 extend from a bottom surface (e.g., the negative Y surface) of the main body 618 of the housing 602. Each of the nests 604 may be a separate component from the main body 618 that is attached to the main body 618 as shown in the illustrated embodiment of Figures 6A-6D, or each of the nests 604 may be integral to the main body 618. The C-shaped end 630A, 630B of each of the risers 606 extends from and at least partially below (e.g., in the negative Y direction) the corresponding one of the nests 604.

Each of the two nests 604 defines a slot 633A, 633B (collectively "slots 633"). Each of the slots 633 in the nests 604 is in communication with the corresponding slot 622 of the housing 602. The riser 606A passes through the slot 633A in the nest 604A and through the slot 622A in the main body 618 as illustrated in Figure 6C to electrically couple to the circuit card 610. In particular, and with combined reference to Figures 6A and 6C, the screw 616A passes through the washer 614A and through a through hole 634A defined in the circuit card 610 to threadably engage the tapped hole 632A of the riser 606A and secure the circuit card 610 to the riser 606A. Similarly, the riser 606B passes through the slot 633B in the nest 604B and through the slot 622B in the main body 618 as illustrated in Figure 6B to electrically couple to the circuit card 610. In particular, the screw 616B passes through the washer 614B and through a through hole 634B defined in the circuit card 610 to threadably engage the tapped hole 632B of the riser 606B and secure the circuit card 610 to the riser 606B in the same manner illustrated for the riser 606A in Figure 6C. In some embodiments, the riser 606A is electrically coupled to a positive terminal (Figure 7) and the riser 606B is electrically coupled to a negative terminal (Figure 7) of the circuit card 610.

Additional details regarding the riser 606B will now be described with respect to Figure 6B, with the understanding that the riser 606A is similarly configured. The C-shaped end 630B includes a top 635 (or positive Y portion) and a bottom 636 (or negative Y portion). The top 635 includes one or more insulation-penetrating members 638B. The bottom 636 includes a clamping member 640B in the form of a threaded set screw. The riser 606A similarly includes one or more insulation-penetrating members 638A and a clamping member 640A, as illustrated in Figure 6C.

Figure 6B additionally illustrates a wire 642B having an insulating jacket 644B, the wire 642B being disposed within the C-shaped end 630B of the riser 606B. Figure 6C similarly illustrates a wire 642A having an insulating jacket 644A, the wire 642A being disposed within the C-shaped end 630A of the riser 606A. The wires 642A, 642B (collectively "wires 642") collectively make up a module-to-module bus, such as the module-to-module bus 104 of Figure 1, for electrically interconnecting the PV module 200 in parallel to other PV modules 200. Each of the wires 642 may be large-area wires. For example, each of the wires 642 may have a cross-sectional area greater than or equal to about 15 mm². Alternately or additionally, each of the wires 642 may have a cross-sectional area in a range from about 15 mm² to about 50 mm².

A method of connecting each of the risers 606 to the wires 642 making up the module-to-module bus will now be described with respect to Figures 6B-6C. Each of the wires 642A, 642B is placed in the C-shaped end 630A, 630B of the corresponding riser 606A, 606B without stripping the insulating jacket 644A, 644B from the wire 642A, 642B during installation. Each clamping member 640A, 640B is then clamped during installation to clamp the corresponding wire 642A, 642B against the corresponding insulation-penetrating members 638A, 638B. The clamping members 640A, 640B may be clamped by screwing the clamping members 640A, 640B to cause the clamping members 640A, 640B to advance towards the insulation-penetrating members 638A, 638B. The clamping of the wires 642A, 642B against the insulation-penetrating members 638A, 638B causes the insulation-penetrating members 638A, 638B to penetrate the insulating jacket 644A, 644B of the corresponding wire 642A, 642B and directly contact the corresponding wire 642A, 642B, thereby electrically coupling each wire 642A, 642B to the corresponding riser 606A, 606B. Although not shown in Figures 6A-6B, in some embodiments, the clamping members 640A, 640B penetrate the insulating jacket 644A, 644B and directly contact the corresponding wire 642A, 642B as well, thereby increasing the direct contact to the wires 642A, 642B.

The above-described method of connecting the risers 606 to the wires 642 allows the electrical connections to the wires 642 to be made without severing the wires 642 and without stripping the insulating jackets 644. As such, the wires 642 making up the module-to-module bus in a PV system, such as the PV system 100, can be continuous. Additionally, the connections can be made without taking the time to strip the insulating jackets 644.

With reference to Figures 6A-6C, each of the caps 608 is attached to a corresponding one of the nests 604 after the wires 642 are connected to the risers 606. Attaching the cap 608A to the riser 606A encloses the C-shaped end 630A and a portion of the wire 642A where the insulating jacket 644A has been penetrated by the insulation-penetrating members 638A within the nest 604A and the cap 608A to protect the connection between the C-shaped end 630A and the wire 642A from environmental contaminants such as moisture. Similarly, attaching the cap 608B to the riser 606B encloses the C-shaped end 630B and a portion of the wire 642B where the insulating jacket 644B has been penetrated by the insulation-penetrating members 638B within the nest 604B and the cap 608B to protect the connection between the C-shaped end 630B and the wire 642B from environmental contaminants. The caps 608 may be snap-on caps and/or may be filled with a moisture-repelling and/or electrically-insulating substance such as silicone or protective grease to further protect the connections between the risers 606 and the wires 642.

With combined reference to Figures 6C-6D, aspects of the cover 612 will be described. The cover 612 may include metal or metal alloys or other thermally-conductive material(s). In some embodiments, the cover 612 is black for enhanced thermal transfer. In the illustrated embodiment, the cover 612 is shaped with various protrusions 646 and/or other features that maximize a surface area of the cover 612 that is externally exposed. A bead of material 648 is sandwiched between the circuit card 610 and the cover 612. The material 648 is thermally conducting and electrically insulating in some embodiments. When fully assembled with the PV module 200, a lower edge 650 of the cover 612 may be in direct contact with or close proximity to (e.g., less than about 8 mm) the frame 208 with an optional bead of thermally-conductive silicone or other material therebetween. Accordingly, thermal energy may be dissipated away from the circuit card 610 by transferring through the material 648 to the cover 612 to be dissipated directly from the cover 612 into the environment, and/or thermal energy may be transferred from the cover 612 to the frame 208 to be dissipated directly from the frame 208 into the environment. Although not shown in Figures 6C-6D, one or more spacers may be provided between the circuit card 610 and the housing 602.

In some embodiments, each of the risers 606 further includes one or more tabs 652 (Figure 6B only). The tabs 652 on each riser 606 extend outward from the riser 606 in both the positive X and negative X directions. In general, the tabs 652 prevent the nests 604 from being removed from the undermount assembly 210 after the risers 606 have been coupled to the circuit card 610. For example, as shown in Figure 6B, the nest 604B includes tabs 654 that extend inward (e.g., in the positive X and negative X directions) toward the riser 606B. The dimensions of the riser 606B and the nest 604B are such that the tabs 652 of the riser 606B acting against the tabs 654 of the nest 604B confine the nest in the negative Y direction to the extent the riser 606B is also confined in the negative Y direction as may occur after the riser 606B has been secured to the circuit card 610. Although not shown in Figure 6C, the nest 604A similarly includes tabs such that the nest 604A is confined in the negative Y direction to the same extent the riser 606A is also confined in the negative Y direction.

### V. Circuit Card

Figure 7 illustrates an example embodiment of the circuit card 610 of Figures 6A-6D, arranged in accordance with at least some embodiments described herein. The circuit card includes multiple converters 702 disposed thereon. The converters 702 may correspond to the converters 116 of Figure 1. Details regarding the converters 116 and other converters have already been described above, which details may also apply to the converters 702. The circuit card 610 additionally includes a digital controller 704 disposed thereon, a positive connector 706, one or more negative connectors 708, a positive terminal 710, and a negative terminal 712. Optionally, the circuit card 610 further includes measurement circuitry 714, a protection relay 716, an opto-relay 718, and a radio frequency (RF)-emitting device 720.

Each of the converters 702 is independently electrically coupled to the positive connector 706 via a corresponding one of multiple fuses 722. With combined reference to Figures 5A and 7, the tab 508A of the internal bus strip 508 extends through the slot 502 in the continuous backsheet 206 and is soldered or otherwise electrically coupled to the positive connector 706 such that the array of PV cells 404 of the PV module 200 is electrically coupled through the serial interconnects 412B, the internal bus strip 508/tab 508A, the positive connector 706 and the fuses 722 to each of the converters 702. As such, energy generated by each of the PV cells 404 is receivable at any of the converters 702. In particular, the energy collectively generated by the array of PV cells 404 is output onto the internal bus strip 508 and can then travel through the tab 508A and the positive connector 706 to any of the converters 702 via a corresponding one of the fuses 722.

The array of PV cells 404 in some embodiments collectively generates about 25 amps to 50 amps of current. The tab 508A and the positive connector 706 are generally dimensioned such that a current-carrying capacity thereof from the PV cells 404 to the converters 702 is significantly greater than a maximum expected current collectively generated by the array of PV cells 404. For example, the current-carrying capacity of the tab 508A and of the positive connector 706 may be about 4-8 times greater than the maximum expected current collectively generated by the array of PV cells 404. Where the maximum expected current is 50 amps, for example, the current-carrying capacity of the tab 508A and of the positive connector 706 may be about 200 amps to about 400 amps. As such, even though the electrical connection between the PV cells 404 and the converters 702 includes a single tab 508A and a single positive connector 706, the electrical connection between the PV cells 404 and the converters 702 is nevertheless redundant since any discrete failure along the length (e.g., the X direction) of the tab 508A and/or the positive connector 706 will not prevent current from flowing through the remaining connection area of the tab 508A and the positive connector 706. Indeed, where the current-carrying capacity of the tab 508A and of the positive connector 706 is only 4 times greater than the maximum expected current collectively generated by the array of PV cells 404, the tab 508A and/or the positive connector 706 could fail along 75% of their length without restricting current flow from the PV cells 404 to the converters 702.

With combined reference to Figures 5B and 7, each of the tabs 504 extends from the continuous backsheet 206 and is soldered or otherwise electrically coupled to a corresponding one of the negative connectors 708 such that the circuit card 610 is grounded through the negative connectors 708 and the tabs 504 to the continuous backsheet 206. As with the tab 508A and the positive connector 706, an aggregate current carrying capacity of tabs 504 and the negative connectors 708 may be 4-8 times greater than the maximum expected current returned through the continuous backsheet 206 to provide redundancy.

The digital controller 704 is communicatively coupled to each of the converters 702 via corresponding paired enable and pulse width modulation (PWM) lines 724. The converters 702 are each controlled independently of the others by the digital controller 704 via the paired enable and PWM lines 724. In some embodiments, the digital controller 704 is powered solely by energy generated by the PV module 200, or more particularly, by energy generated by the PV cells 404 of the PV module 200. During non-monotonically increasing or decreasing illumination conditions of the PV module 200, a discrete or integrated brown-out circuit (not shown) may be used to ensure the digital controller 704 is not corrupted.

In operation, energy generated by the PV cells 404 flows from the positive connector 706 through one of the fuses 722 into a corresponding one of the converters 702, which outputs energy with a relatively lower current and higher voltage onto an output bus 726 of the circuit card 610. Any number of converters 702 from zero up to all of the converters 702 may operate at a given time.

The output bus 726 is electrically coupled to outputs of each of the converters 702 and is thus common to all of the converters 702. The output bus 726 may be at about 48 volts during operation. The output bus 726 is coupled through the protection relay 716 to the positive terminal 710. The protection relay 716 may include a mechanical relay, a solid state relay, or other suitable relay and in some embodiments defaults open. When the protection relay 716 is closed, energy on the output bus 726 can be output through the positive terminal 710 (and the riser 606A of Figure 6C) to a module-to-module bus (including the wire 642A of Figure 6C). Opening the protection relay 716 electrically disconnects the output bus 726 from the module-to-module bus.

The opto-relay 718 is coupled to the output bus 726 and the positive terminal 710. The opto-relay 718 is used to measure positive voltage on the module-to-module bus for zero-current relay switching and also to recharge a capacitor bank, e.g., by feeding current into the module-to-module bus, for capacitance-only systems (e.g., no storage devices).

The measurement circuitry 714 detects current coming into the PV module 200 via the negative terminal 712 from the module-to-module bus. In other embodiments, the measurement circuitry 714 detects current going out of the PV module 200 via the positive terminal 710. In some embodiments, the measurement circuitry 714 measures current input (or current output) from (or to) the module-to-module bus at the negative terminal 712 (or the positive terminal 710) while the digital controller 704 estimates current output (or current input) to (or from) the module-to-module bus at the positive terminal 710 (or the negative terminal 712).

In some embodiments, the digital controller 704 estimates the current output (or current input) based on one or more of: the number of operating converters 702, PWM values of the operating converters 702, voltage collectively generated by the PV cells 404, output voltage to the module-to-module bus, combined with a look-up table to correct for some errors. The measurement from the measurement circuit 714 is received at the digital controller 704 and compared with the estimate to monitor current offset between the input and output. If the input and output do not match within a specific limit or percentage of the output, the digital controller 704 can switch off the operating converters 702 to discontinue sending power onto the module-to-module bus. Alternately or additionally, the digital controller 704 may monitor the input and/or output current and may limit current flow in the case where the output current exceeds a preset limit. In these and other embodiments, the measurement circuitry 714 may include a resistor and/or an op-amp.

During operation, one or more of the converters 702 may fail. For example, one or more of the converters 702 may experience a finite resistance short failure. In these and other embodiments, the digital controller 704 may temporarily disable the other converters 702 to temporarily route all current collectively generated by the PV cells 404 through the failed converter 702 until the corresponding fuse 722 opens. In response to the corresponding fuse 722 opening, the digital controller 704 may resume normal operation using at least some of the remaining converters 702 by enabling the corresponding converters 702.

As illustrated in Figure 7, the converters 702 are disposed in a line on the circuit card 610. The converters 702 in some embodiments have a spacing of less than 3 mm between adjacent converters 702. Figure 7 additionally illustrates that the converters 702 are generally disposed near the positive connector 706. In some embodiments, each of the converters 702 is disposed within a range of about 2 mm to about 10 mm from the positive connector 706. Due to the proximity of the converters 702 to the positive connector 706, high current losses from the positive connector 706 to each of the converters 702 may be minimized compared to configurations where the converters 702 are located further from the positive connector 706.

The converters 702 in some embodiments are operated offset from each other. For example, the six converters 702 of Figure 7 may be operated in three pairs, each operating pair operating offset from (e.g., out of phase with) the other operating pairs. In some embodiments, the operating pairs are offset by 120 degrees from each other. The two converters within each operating pair may be operated at 180 degrees out of phase with each other. In other embodiments, the circuit card 610 may include any desired number of converters 706 which may be divided into any desired number of operating pairs offset by any desired phase offset, where the two converters within each operating pair are operated at any desired phase offset from each other.

The RF-emitting device 720 is communicatively coupled to the digital controller 704. The digital controller 704 is configured to operate the RF-emitting device 720 to transmit information to or receive information from other PV modules 200 in a PV system including multiple PV modules 200, such as the PV system 100 of Figure 1. Alternately or additionally, the digital controller 704 may be configured to operate the RF-emitting device 720 to transmit information to or receive information from a data collection device included in the PV system. In some embodiments, if one of the PV modules 200 is out of direct transmission distance from the data collection device, for instance, the information from the PV module 200 may be transmitted to the data collection device by essentially operating one or more intermediary PV modules 200 as relay nodes. Thus, each PV module 200 may transmit to or receive data from other PV modules 200 and/or the data collection device.

Optionally, the circuit card 610 further includes an optical signal source 728 communicatively coupled to the digital controller 704 and mounted to the circuit card 610 near the top (e.g., positive Y side) of the circuit card 610 such that optical signals emitted by the optical signal source 728 are visible from the front of the PV module 200. The optical signal source 728 may include a 90-degree surface mount light-emitting diode (LED), a surface mount laser, or other suitable optical signal source.

The PV module 200 includes various intervening layers between the optical signal source 728 and the front of the PV module 200, such as the continuous backsheet 206, the buffer layer 408, the PV cells 404 and the adhesive layer 406. A hole may be formed through one or more of the intervening layers so that optical signals emitted by the optical signal source are visible through the intervening layers from the front of the PV module 200. Alternately or additionally, some or all of the intervening layers may be translucent and/or may already include an opening formed therein-such as the slot 502 formed in the continuous backsheet 206-such that optical signals emitted by the optical signal source 728 are visible from the front of the PV module 200 without forming a hole in some or all of the intervening layers.

In some embodiments, the digital controller 704 operates the optical signal source 728 to emit optical signals comprising status information. The emitted optical signals may include visually-recognizable (e.g., by a human) patterns that convey the status information. The status information may include power and fault codes and is used in some embodiments for debugging, detecting failures, confirmation location of panels, or other purposes.

Alternately or additionally, the emitted optical signals include packets of bits that may be interpreted by a computing device coupled to a photodiode or other optical receiver. The packets of bits include more detailed status information than might otherwise be communicated in by the visually-recognizable patterns, such as a module serial ID for the PV module 200, full fault logs, accumulated energy production for the PV module 200, a temperature of the PV module 200, a number of on/off cycles of the PV module 200, or the like or any combination thereof.

Figure 8 illustrates an example power/voltage curve 802 for the PV module 200 of Figure 2, arranged in accordance with at least some embodiments described herein. Example operation of the PV module 200 will now be described with combined reference to Figures 2-8. The circuit card 610, including the digital controller 704, is powered directly by the energy generated by the PV module 200 and not from an external supply. As such, the circuit card 610 is not powered in the absence of illumination, such as at night. Under sufficient illumination, the PV cells 404 generate sufficient voltage for the digital controller 704 to begin operating.

The first operation performed by the digital controller 704 is to perform a series of checks to ensure safe module operation. For example, the digital controller 704 checks the voltage on the module-to-module bus by controlling the opto-relay 718 to measure the voltage on the module-to-module bus. If the voltage is above a maximum threshold 804, the digital controller 704 does not allow energy to be output to the module-to module bus by causing the protection relay 716 to open or remain open (as previously mentioned, the protection relay 716 may default open). Instead, any energy generated by the PV cells 404 and received at the converters 702 may be shunted back into the PV cells 404 through the continuous backsheet 206 while the digital controller 704 continues monitoring the voltage on the module-to-module bus. The maximum threshold 804 is 60 volts in the example of Figure 8.

When the voltage on the module-to-module bus is less than a minimum threshold 806, such as 35 volts in the example of Figure 8, the digital controller 704 controls the opto-relay 718 to trickle charge current from the output bus 726 to the module-to-module bus to determine whether a capacitive element is attached to the module-to-module bus. If the digital controller 704 determines that a capacitive element is attached to the module-to-module bus, the digital controller 704 continues to trickle charge current through the opto-relay 718 to the module-to-module bus until the voltage on the module-to-module bus rises above the minimum threshold 806.

When the voltage on the module-to-module bus rises above the minimum threshold 806, the digital controller 704 closes the protection relay 716 to ensure zero current switching. The digital controller 704 operates the converters 702 in a maximum current mode when the voltage on the module-to-module bus is between the minimum threshold 806 and an intermediate threshold 808 greater than the minimum threshold 806. The intermediate threshold 808 is 57 volts in the example of Figure 8. The digital controller 704 operates the converters 702 in a constant voltage mode when the voltage on the module-to-module bus is between the intermediate threshold 808 and the maximum threshold 804 and opens the protection relay 716 when the voltage on the module-to-module bus rises above the maximum threshold 804 or falls below the minimum threshold 806.

If the voltage on the module-to-module bus is already greater than the minimum threshold 806 and less than the intermediate threshold 808 when the digital controller 704 first measures the voltage, the digital controller 704 charges up (e.g., operates) the converters 702 until the voltage on the output bus 726 matches the voltage on the module-to-module bus before closing the protection relay 716 to ensure zero current switching of the protection relay 716. As already described above, the digital controller 704 will then operate the converters 702 in maximum current mode or constant voltage mode, or will open the protection relay 716, depending on the voltage on the module-to-module bus.

Accordingly, the protection relay 716 enables a soft start control where the PV module 200 is isolated from the voltage on the module-to-module bus until one or more of the converters 702 are charged so that the voltage on the output bus 726 matches the voltage on the module-to-module bus before closing the protection relay 716. In these and other embodiments, the opto-relay 718 is a bypass circuit around the protection relay 716 that allows measurement of the external voltage on the module-to-module bus to ensure that the soft start is balanced, and to allow some small current to be fed into the module-to-module bus to assist in charging a capacitive element on the module-to-module bus in the event an energy storage device is not coupled thereto.

In a PV system, such as the PV system 100 of Figure 1, that includes multiple PV modules 200, each of the PV modules 200 operates independently of the others depending only on the voltage on the module-to-module bus as described herein, ensuring redundancy by eliminating dependencies on other PV modules 200.

Maximum current mode includes operating any number, from one to all, of the converters 702 so as to produce a maximum current output on the output bus 726. The number of converters 702 operated at any given time depends on the amount of available current from the PV cells 404, which is determined by changing PWM values of any single operating converter 702 and observing the resulting voltage change and power. If the voltage change is minimal and the power increases, a maximum peak power algorithm is executed, as described in more detail below. As the maximum peak power algorithm reaches optimum PWM values for the converters 702, additional converters 702 may be enabled to continue taking (and outputting) more power. If the power decreases and the PWM values for the operating converters 702 fall below a threshold, one of the operating converters 702 may be disabled.

If one of the operating converters 702 experiences a failure, the digital controller 704 may identify the failed converter 702 in memory. If the converter 702 fails short, the digital controller 704 may temporarily disable the other operating converters 702 and temporarily route all current through the failed converter 702 and its fuse 722 to open the fuse 722 as already explained above.

### VI. Converters

Figure 9 is a schematic diagram of an embodiment of one of the converters 702 of Figure 7, arranged in accordance with at least some embodiments described herein. Each of the converters 702 may be similarly configured. The converter 702 illustrated in Figure 9 is merely one example of a converter that can be employed according to some embodiments and should not be construed to limit the invention in any way.

As shown in Figure 9, the converter 702 includes an input 902, a capacitor 904 coupled to the input 902 and to ground 906, an inductor 908 coupled to the input 902 and to the capacitor 904, a switch 910 coupled to the inductor 908, a diode 912 coupled to the inductor 908 and to the switch 910, an output 914 coupled to the diode 912, a control line 916 coupled to the switch 910, and one or more measurement circuits 918 coupled between the converter 702 and ground 906.

With combined reference to Figures 2-9, the input 902 is electrically coupled to the positive connector 706 through a corresponding fuse 722. The ground 906 is electrically coupled to the continuous backsheet 206 through one of the negative connectors 708 and a corresponding one of the tabs 504. The output 914 is electrically coupled to the output bus 726. The control line 916 is communicatively coupled to the digital controller 704 and may correspond to one of the paired enable and PWM lines 724.

The digital controller 704 provides, via the control line 916, a PWM signal to the switch 910 that controls the switching frequency and/or duty cycle of the converter 702. Alternately or additionally, the PWM signal controls the phasing of the converter 702 relative to the phasing of other converters 702 on the circuit card 610.

The switch 910 may include a field-effect transistor ("FET"), a metal-oxide-semiconductor FET ("MOSFET"), an insulated-gate bipolar transistor ("IGBT"), a bipolar junction transistor ("BJT"), or other suitable switch. The diode 912 may include a Schottky rectifier, or other suitable diode.

The measurement circuit 918 includes one or more resistors and is employed to measure certain operating parameters of the converter 702. For instance, the measurement circuit 918 can measure the maximum current buildup per switching cycle in the inductor 908 in order to maintain maximum peak power. Alternately or additionally, the measurement circuit 918 can measure the charging rate of the inductor 908, the input voltage of the converter 702, the output voltage of the converter 702, or the like or any combination thereof.

In operation, the converter 702 receives energy generated by any of the PV cells 404 at the input 902 and converts it to have a relatively higher voltage (referred to as the "step-up voltage") and a lower current by switching itself on and off via the switch 910. In the "on" state, the switch 910 is closed such that the current flowing through the inductor 908 increases and returns to ground 906 through the switch 910 and the measurement circuit 918. In the "off" state, the switch 910 is open such that the current flowing through the inductor 908 decreases, flowing through the diode 912 and the output 914 to the output bus 726.

In the "on" state of the converter 702, the voltage at the output 914 is about 0 volts. In the "toff" state, the voltage at the output 914 depends on the rate of change of current through the inductor 908, rather than on the input voltage at the input 902. In turn, the rate of change of current through the inductor 908 depends on the inductance of the inductor 908. Accordingly, the step-up voltage at the output 914 depends on the inductance of the inductor 908. Alternately or additionally, the step-up voltage at the output 914 depends on the switching frequency of the switch 910 and/or the duty cycle of the switch 910.

In a continuous conduction mode, the current through the inductor 908 never reaches 0 amps. By cycling the converter 702 on and off in or near continuous conduction mode, the converter 702 produces conditioned power (e.g., power having the step-up voltage) at the output 914 while maximizing efficiency and minimizing peak current in the converter 702. Alternately or additionally, the converter 702 may be operated near continuous conduction mode by limiting the duty cycle D of the converter 702 to [(V_out - V_in) / V_out - 0.05] < D < 0.75, where V_out and V_in are the output voltage and the input voltage of the converter 702 and may be measured by the measurement circuit 918.

In this and other embodiments, the switch 910 is operated via the control line 916. In particular, the digital controller 704 sends signals over the control line 916 to open and close the switch 910 at a desired frequency and duty cycle. Because each of the step-up voltage and the impedance of the converter 702 depend on the frequency and the duty cycle of the switching process, the digital controller 704 can set the frequency and/or duty cycle at a predetermined frequency and/or duty cycle to optimize the step-up voltage and the impedance of the converter 702. Thus, any individual converter 702 on the circuit card 610 may only be partially used in both duty cycle and frequency and may be part of a dynamic load-leveling cycle.

In some embodiments, the increasing and decreasing current through the inductor 908 can cause periodic variations in the amplitude of the input current and/or the output current of the converter 702. These periodic variations in the current amplitude are also known as current ripple. Current ripple at the input 902 of the converter 702 can cause the impedance of the converter 702 to vary as a function of the current ripple, making it difficult for the converter 702 to maintain maximum peak power. Current ripple at the output of the converter 702 can result in noise on the output bus 726 that may negatively affect a load coupled to the output bus 726.

However, current ripple can be substantially reduced at the input and output of the circuit card 610 as a whole by operating the converters 702 out of phase with each other. When the converters 702 are operating out of phase with each other, the amplitude of current ripple in one of the converters 702 may be increasing while the amplitude of current ripple in another of the converters 702 may be decreasing. The cumulative effect of the out-of-phase operation of the converters 702 averages out the current ripple at the input and output of the circuit card 610 as a whole.

As mentioned above, the maximum value of the current buildup and/or the charging rate of the inductor 908 may be used by the converters 702 in maintaining peak power of the PV module 200. Maintaining peak power can maximize the unconditioned power output of the array of PV cells 404, and consequently of the conditioned power output to the module-to-module bus. In general, maintaining peak power includes (1) identifying a peak power point at which power output of the array of PV cells 404 is maximized and (2) dynamically varying the impedance of the converters 702 to effectively match the impedance of a load such that the voltage across the array of PV cells 404 is substantially equal to the identified peak power point. Moreover, as explained above with respect to Figure 1, the load coupled to the module-to-module bus may be optimized to operate over a very narrow voltage range for maximum efficiency.

The embodiments described herein may include the use of a special purpose or general purpose computer, including various computer hardware or software modules, as discussed in greater detail below.

Embodiments within the scope of the present invention also include computer-readable media for carrying or having computer-executable instructions or data structures stored thereon. Such computer-readable media can be any available media that can be accessed by a general purpose or special purpose computer. By way of example, and not limitation, such computer-readable media can include tangible computer-readable storage media including RAM, ROM, EEPROM, CD-ROM or other optical disk storage, magnetic disk storage or other magnetic storage devices, or any other storage medium which can be used to carry or store desired program code means in the form of computer-executable instructions or data structures and which can be accessed by a general purpose or special purpose computer. Combinations of the above should also be included within the scope of computer-readable media.

Computer-executable instructions comprise, for example, instructions and data which cause a general purpose computer, special purpose computer, or special purpose processing device to perform a certain function or group of functions. Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

As used herein, the term "module" or "component" can refer to software objects or routines that execute on the computing system. The different components, modules, engines, and services described herein may be implemented as objects or processes that execute on the computing system (e.g., as separate threads). While the system and methods described herein are preferably implemented in software, implementations in hardware or a combination of software and hardware are also possible and contemplated. In this description, a "computing entity" may be any computing system as previously defined herein, or any module or combination of modulates running on a computing system.

The present invention may be embodied in other specific forms without departing from its spirit or essential characteristics. The described embodiments are to be considered in all respects only as illustrative and not restrictive. The scope of the invention is, therefore, indicated by the appended claims rather than by the foregoing description. All changes which come within the meaning and range of equivalency of the claims are to be embraced within their scope.

## Claims

1. A photovoltaic system (100) comprising:
a plurality of photovoltaic modules (102, 200), each photovoltaic module (102, 200) defining a first end (110, 202) and a second end (112, 204) opposite the first end (110, 202), wherein each photovoltaic module (102, 200) comprises:
a plurality of photovoltaic cells (114, 404), wherein energy generated by each photovoltaic cell (114,404) has multiple paths through the plurality of photovoltaic cells (114, 404) to the second end (112, 204); and
a plurality of converters (702) electrically coupled to the plurality of photovoltaic cells (114, 404) at the second end (112, 204) such that energy generated by each photovoltaic cell (114, 404) is receivable at any of the plurality of converters (702);
a continuous backsheet (206, 206A, 206B), the continuous backsheet (206, 206A, 206B) comprising a ground plane for the plurality of photovoltaic cells (114, 404);
wherein the continuous backsheet (206, 206A, 206B) is electrically coupled between a first subset (416) of the plurality of photovoltaic cells (114, 404) at the first end (110, 202) and a second subset (506) of the plurality of photovoltaic cells (114, 404) at the second end (112, 204), wherein the continuous backsheet (206, 206A, 206B) is configured to carry module return current from the second end (112, 204) to the first end (110, 202);
a first end connection (418, 412A) between the continuous backsheet (206, 206A, 206B) and the first subset (416) of the plurality of photovoltaic cells (114, 404) at the first end (110, 202);
a second end connection (412B, 508) between the plurality of converters (702) and the second subset (506) of the plurality of photovoltaic cells (114, 404) at the second end (112, 204);
a circuit card (610) mechanically coupled to the second end (112, 204), the circuit card (610) including the plurality of converters (702) disposed thereon and further including a positive connector (706) and a negative connector (708);
an internal bus strip (508) extending along a width of the photovoltaic module (102, 200), wherein the internal bus strip (508) is coupled to each of the photovoltaic cells (114, 404) in the second subset (506) of the plurality of photovoltaic cells (114, 404); and
a module-to-module bus (104) electrically coupled to each of the plurality of photovoltaic modules (102, 200), the module-to-module bus (104) having an output, wherein energy generated by each photovoltaic module (102, 200) is receivable at the output independent of any other of the plurality of photovoltaic modules (102, 200),
wherein one or more tabs (306A, 306B, 308A, 308B) extend from the continuous backsheet (206, 206A, 206B) to one of the connectors (706, 708) of the circuit card (610), the one or more tabs (306A, 306B, 308A, 308B) electrically coupling the continuous backsheet (206, 206A, 206B) to that one of the connectors (706, 708) of the circuit card (610),
**characterized in that**
the internal bus strip (508) includes a tab (508A) extending from the internal bus strip (508) through a slot (304) or a cutout (310) formed in the continuous backsheet (206, 206A, 206B) to the other one of the connectors (706, 708) of the circuit card (610), the tab (508A) electrically coupling the internal bus strip (508) to that one of the connectors (706, 708) of the circuit card (610).

2. The photovoltaic system (100) of claim 1, wherein each of the plurality of photovoltaic modules (102, 200) further comprises:
a digital controller (704) disposed on the circuit card (610);
wherein the plurality of converters (702) are each controlled independently of the others by the digital controller (704) via paired enable and pulse width modulation (PWM) lines 724 from the digital controller (704) to each of the plurality of converters (702); and
the digital controller (704) of each of the photovoltaic modules (102, 200) is configured to:
trickle charge current onto the module-to-module bus (104) when a voltage on the module-to-module bus (104) is less than a minimum threshold (806) to determine whether a capacitive element is attached to the module-to-module bus (104);
in response to determining that a capacitive element is attached to the module-to-module bus (104), continue to trickle charge current onto the module-to-module bus (104) until the voltage on the module-to-module bus (104) rises above the minimum threshold (806);
close a protection relay (716) when the voltage on the module-to-module bus (104) rises above the minimum threshold (806) to ensure zero current switching, the protection relay (716) being electrically coupled between the module-to-module bus (104) and an output bus (726) of the circuit card (610), the output bus (726) being electrically coupled to outputs (914) of each of the plurality of converters (702);
operate the plurality of converters (702) in a maximum current mode when the voltage on the module-to-module bus (104) is between the minimum threshold (806) and an intermediate threshold (808) greater than the minimum threshold (806);
operate the plurality of converters (702) in a constant voltage mode when the voltage on the module-to-module bus (104) is between the intermediate threshold (808) and a maximum threshold (804) greater than the minimum threshold (806); and open the protection relay (716) when the voltage on the module-to-module bus (104) rises above the maximum threshold (804) or falls below the minimum threshold (806).

3. The photovoltaic system (100) of claim 1, wherein:
the plurality of photovoltaic cells (114, 404) are arranged in a plurality of rows (416, 506) electrically coupled in series;
each of the plurality of photovoltaic modules (102, 200) further comprises a plurality of conductive row strips (414) electrically coupling the photovoltaic cells (114, 404) in each row (416, 506) to each other in parallel; and
the multiple paths through the plurality of photovoltaic cells (114, 404) to the second end (112, 204) include the plurality of conductive row strips (414) such that generated current can flow, via the plurality of conductive row strips (414), around photovoltaic cells (114, 404) with low performance and/or low illumination and through photovoltaic cells (114, 404) with relatively higher performance and/or higher illumination to the second end (112, 204).

4. The photovoltaic system (100) of claim 1, wherein:
the first end connection (418, 412A) between the continuous backsheet (206, 206A, 206B) and the first subset (416) of the plurality of photovoltaic cells (114, 404) at the first end (110, 202) comprises an anode of the photovoltaic module (102, 200);
the second end connection (412B, 508) between the plurality of converters (702) and the second subset (506) of the plurality of photovoltaic cells (114, 404) at the second end (112, 204) comprises a cathode of the photovoltaic module (102, 200); and
the continuous backsheet (206, 206A, 206B) is configured to carry module return current from the cathode to the anode.

5. The photovoltaic system (100) of claim 4, wherein
the internal bus strip (508) is coupled to a cathode of each of the photovoltaic cells (114, 404) in the second subset (506) of the plurality of photovoltaic cells (114, 404); and
the tab (508A) of the internal bus strip (508) electrically couples the internal bus strip (508) to the positive connector (706) of the circuit card (610); and
wherein the one or more tabs (306A, 306B, 308A, 308B) extend from the continuous backsheet (206, 206A, 206B) to the negative connector (708) of the circuit card (610), the one or more tabs (306A, 306B, 308A, 308B) electrically coupling the continuous backsheet (206, 206A, 206B) to the negative connector (708) of the circuit card (610).

6. The photovoltaic system (100) of claim 2, wherein each of the plurality of photovoltaic modules (102, 200) further includes an optical signal source (728) communicatively coupled to the digital controller (704) and mounted to the circuit card (610) such that optical signals emitted by the optical signal source (728) are visible from a front of the corresponding photovoltaic module (102, 200).

7. The photovoltaic system (100) of claim 2, wherein each of the plurality of photovoltaic modules (102, 200) further comprises a radio frequency (RF)-emitting device (720) communicatively coupled to the digital controller (704), the digital controller (704) being configured to operate the RF-emitting device (720) to transmit information to others of the plurality of photovoltaic modules (102, 200) and/or to a data collection device included in the photovoltaic system (100).

8. The photovoltaic system (100) of claim 2, wherein each of the plurality of photovoltaic modules (102, 200) further comprises an undermount assembly (210) within which the circuit card (610) is disposed, the undermount assembly (210) including a housing (602) comprising:
a main body (618); and
a plurality of feet (620A-620C) extending from the main body (618), the plurality of feet (620A-620C) being substantially coplanar,
wherein:
the undermount assembly (210) is mechanically coupled to the continuous backsheet (206, 206A, 206B) of the corresponding photovoltaic module (102, 200) using an adhesive or tape (626) disposed between the continuous backsheet (206, 206A, 206B) and the plurality of feet (620A-620C); and
the main body (618) defines two slots (622A, 622B) through which two corresponding risers (606A, 606B) pass through the main body (618) to electrically couple to the circuit card (610).

9. The photovoltaic system (100) of claim 1, wherein each of the plurality of converters (702) is operated with a duty cycle D in a range from [(V_out - V_in) / V_out - 0.05] < D < 0.75, where V_out and V in are an output voltage and an input voltage of the corresponding converter (702).

10. The photovoltaic system (100) of claim 1, wherein each of the plurality of photovoltaic modules (102, 200) further comprises:
measurement circuitry (714) configured to measure an output current to the module-to-module bus (104) or an input current from the module-to-module bus (104); and
a digital controller (704) configured to, based on the measurement, monitor an offset between the output current and the input current and/or to limit output current when the output current exceeds a preset limit.

11. The photovoltaic system (100) of claim 1, further comprising:
a plurality of inverters (106) electrically coupled to the module-to-module bus (104) such that energy generated by each photovoltaic module (102, 200) is receivable at any of the plurality of inverters (106).

12. The photovoltaic system (100) of claim 11, wherein one or more energy storage devices (108) are coupled in parallel to the module-to-module bus (104).

13. The photovoltaic system (100) of claim 12, wherein based on a DC setpoint and AC curtailment of each of the plurality of inverters (106) and on a current state of charge of the one or more energy storage devices (108), current flows through the module-to-module bus (104) and one or more of the plurality of inverters (106):
into the one or more energy storage devices (108) from any or all phases of a multiphase AC power grid (118) to which each of the plurality of inverters (106) is coupled; or
from the one or more energy storage devices (108) into any or all phases of the multiphase AC power grid (118).

14. The photovoltaic system (100) of claim 11, wherein each of the plurality of inverters (106) is configured to be further coupled to any or all three phases of a three-phase AC power grid (118).

15. The photovoltaic system (100) of claim 11, wherein:
the plurality of inverters (106) comprise three inverters (106);
each of the three inverters (106) is further coupled to a different phase of a three-phase AC power grid (118) using a Wye or Delta connection; and
each of the three inverters (106) has a different DC setpoint such that during operation current flows:
from one or more phases of the three-phase AC power grid (118) through one or more of the plurality of inverters (106) with a relatively high DC setpoint to the module-to-module bus (104); and
from the module-to-module bus (104) through one or more of the plurality of inverters (106) with a relatively low DC setpoint to one or more other phases of the three-phase AC power grid (118).

## Patentansprüche

1. Photovoltaiksystem (100), umfassend:
mehrere Photovoltaikmodule (102, 200), wobei jedes Photovoltaikmodul (102, 200) ein erstes Ende (110, 202) und ein zweites Ende (112, 204) gegenüber dem ersten Ende (110, 202) definiert, wobei jedes Photovoltaikmodul (102, 200) Folgendes umfasst:
mehrere Photovoltaikzellen (114, 404), wobei Energie, die durch jede Photovoltaikzelle (114, 404) erzeugt wird, mehrere Pfade durch die mehreren Photovoltaikzellen (114, 404) zum zweiten Ende (112, 204) aufweist; und
mehrere Umsetzer (702), die elektrisch mit den mehreren Photovoltaikzellen (114, 404) am zweiten Ende (112, 204) gekoppelt sind, so dass Energie, die durch jede Photovoltaikzelle (114, 404) erzeugt wird, an einem beliebigen der mehreren Umsetzer (702) empfangen werden kann;
eine durchgehende Rückwand (206, 206A, 206B), wobei die durchgehende Rückwand (206, 206A, 206B) eine Grundplatte für die mehreren Photovoltaikzellen (114, 404) umfasst;
wobei die durchgehende Rückwand (206, 206A, 206B) elektrisch zwischen einer ersten Teilmenge (416) der mehreren Photovoltaikzellen (114, 404) am ersten Ende (110, 202) und einer zweiten Teilmenge (506) der mehreren Photovoltaikzellen (114, 404) am zweiten Ende (112, 204) gekoppelt ist, wobei die durchgehende Rückwand (206, 206A, 206B) dazu konfiguriert ist, einen Modulrückstrom vom zweiten Ende (112, 204) zum ersten Ende (110, 202) zu führen;
eine erste Endverbindung (418, 412A) zwischen der durchgehenden Rückwand (206, 206A, 206B) und der ersten Teilmenge (416) der mehreren Photovoltaikzellen (114, 404) am ersten Ende (110, 202);
eine zweite Endverbindung (412B, 508) zwischen den mehreren Umsetzern (702) und der zweiten Teilmenge (506) der mehreren Photovoltaikzellen (114, 404) am zweiten Ende (112, 204);
eine Schaltungskarte (610), die mechanisch mit dem zweiten Ende (112, 204) gekoppelt ist, wobei die Schaltungskarte (610) die mehreren Umsetzer (702) darauf angeordnet beinhaltet und ferner einen positiven Anschluss (706) und einen negativen Anschluss (708) beinhaltet;
einen internen Busstreifen (508), der sich entlang einer Breite des Photovoltaikmoduls (102, 200) erstreckt, wobei der interne Busstreifen (508) mit jeder der Photovoltaikzellen (114, 404) in der zweiten Teilmenge (506) der mehreren Photovoltaikzellen (114, 404) gekoppelt ist; und
einen Modul-Modul-Bus (104), der elektrisch mit jedem der mehreren Photovoltaikmodule (102, 200) gekoppelt ist, wobei der Modul-Modul-Bus (104) einen Ausgang aufweist, wobei Energie, die durch jedes Photovoltaikmodul (102, 200) erzeugt wird, unabhängig von einem jeglichen anderen der mehreren Photovoltaikmodule (102, 200) am Ausgang empfangen werden kann,
wobei sich ein oder mehrere Abgriffe (306A, 306B, 308A, 308B) von der durchgehenden Rückwand (206, 206A, 206B) zu einem der Anschlüsse (706, 708) der Schaltungskarte (610) erstreckt bzw. erstrecken, wobei der eine oder die mehreren Abgriffe (306A, 306B, 308A, 308B) die durchgehende Rückwand (206, 206A, 206B) elektrisch mit dem einen der Anschlüsse (706, 708) der Schaltungskarte (610) koppelt bzw. koppeln,
**dadurch gekennzeichnet, dass**
der interne Busstreifen (508) einen Abgriff (508A) beinhaltet, der sich vom internen Busstreifen (508) durch einen Schlitz (304) oder einen Ausschnitt (310), der in der durchgehenden Rückwand (206, 206A, 206B) ausgebildet ist, zum anderen der Anschlüsse (706, 708) der Schaltungskarte (610) erstreckt, wobei der Abgriff (508A) den internen Busstreifen (508) elektrisch mit dem einen der Anschlüsse (706, 708) der Schaltungskarte (610) koppelt.

2. Photovoltaiksystem (100) nach Anspruch 1, wobei jedes der mehreren Photovoltaikmodule (102, 200) ferner Folgendes umfasst:
eine digitale Steuerung (704), die auf der Schaltungskarte (610) angeordnet ist;
wobei die mehreren Umsetzer (702) jeweils unabhängig voneinander durch die digitale Steuerung (704) über gekoppelte Freigabe- und Pulsweitenmodulations(PWM)-Leitungen 724 von der digitalen Steuerung (704) zu jedem der mehreren Umsetzer (702) gesteuert werden; und
wobei die digitale Steuerung (704) von jedem der Photovoltaikmodule (102, 200) zu Folgendem konfiguriert ist:
langsames Laden von Strom auf den Modul-Modul-Bus (104), wenn eine Spannung auf dem Modul-Modul-Bus (104) geringer als eine Minimalschwelle (806) ist, um zu bestimmen, ob ein kapazitives Element am Modul-Modul-Bus (104) angebracht ist;
als Reaktion auf das Bestimmen, dass ein kapazitives Element am Modul-Modul-Bus (104) angebracht ist, Fortfahren, Strom langsam auf den Modul-Modul-Bus (104) zu laden, bis die Spannung auf dem Modul-Modul-Bus (104) über die Minimalschwelle (806) ansteigt;
Schließen eines Schutzrelais (716), wenn die Spannung auf dem Modul-Modul-Bus (104) über die Minimalschwelle (806) ansteigt, so dass eine Nullstromschaltung gewährleistet wird, wobei das Schutzrelais (716) elektrisch zwischen dem Modul-Modul-Bus (104) und einem Ausgangsbus (726) der Schaltungskarte (610) gekoppelt ist, wobei der Ausgangsbus (726) elektrisch mit Ausgängen (914) von jedem der mehreren Umsetzer (702) gekoppelt ist;
Betreiben der mehreren Umsetzer (702) in einem Maximalstrommodus, wenn die Spannung auf dem Modul-Modul-Bus (104) zwischen der Minimalschwelle (806) und einer Zwischenschwelle (808), die größer als die Minimalschwelle (806) ist, liegt;
Betreiben der mehreren Umsetzer (702) in einem Modus mit konstanter Spannung, wenn die Spannung auf dem Modul-Modul-Bus (104) zwischen der Zwischenschwelle (808) und einer Maximalschwelle (804), die größer als die Minimalschwelle (806) ist, liegt; und
Öffnen des Schutzrelais (716), wenn die Spannung auf dem Modul-Modul-Bus (104) über die Maximalschwelle (804) ansteigt oder unter die Minimalschwelle (806) fällt.

3. Photovoltaiksystem (100) nach Anspruch 1, wobei:
die mehreren Photovoltaikzellen (114, 404) in mehreren Reihen (416, 506), die elektrisch in Reihe gekoppelt sind, angeordnet sind;
jedes der mehreren Photovoltaikmodule (102, 200) ferner mehrere leitfähige Reihenstreifen (414) umfasst, die die Photovoltaikzellen (114, 404) in jeder Reihe (416, 506) elektrisch parallel miteinander koppeln; und
die mehreren Pfade durch die mehreren Photovoltaikzellen (114, 404) zum zweiten Ende (112, 204) die mehreren leitfähigen Reihenstreifen (414) beinhalten, so dass ein erzeugter Strom über die mehreren leitfähigen Reihenstreifen (414) um Photovoltaikzellen (114, 404) herum mit niedriger Leistung und/oder niedriger Illumination und durch Photovoltaikzellen (114, 404) mit relativ hoher Leistung und/oder hoher Illumination zum zweiten Ende (112, 204) fließen kann.

4. Photovoltaiksystem (100) nach Anspruch 1, wobei:
die erste Endverbindung (418, 412A) zwischen der durchgehenden Rückwand (206, 206A, 206B) und der ersten Teilmenge (416) der mehreren Photovoltaikzellen (114, 404) am ersten Ende (110, 202) eine Anode des Photovoltaikmoduls (102, 200) umfasst;
die zweite Endverbindung (412B, 508) zwischen den mehreren Umsetzern (702) und der zweiten Teilmenge (506) der mehreren Photovoltaikzellen (114, 404) am zweiten Ende (112, 204) eine Kathode des Photovoltaikmoduls (102, 200) umfasst und
die durchgehende Rückwand (206, 206A, 206B) dazu konfiguriert ist, einen Modulrückstrom von der Kathode zur Anode zu führen.

5. Photovoltaiksystem (100) nach Anspruch 4, wobei
der interne Busstreifen (508) mit einer Kathode von jeder der Photovoltaikzellen (114, 404) in der zweiten Teilmenge (506) der mehreren Photovoltaikzellen (114, 404) gekoppelt ist; und der Abgriff (508A) des internen Busstreifens (508) den internen Busstreifen (508) elektrisch mit dem positiven Anschluss (706) der Schaltungskarte (610) koppelt; und
wobei sich der eine oder die mehreren Abgriffe (306A, 306B, 308A, 308B) von der durchgehenden Rückwand (206, 206A, 206B) zum negativen Anschluss (708) der Schaltungskarte (610) erstreckt bzw. erstrecken, wobei der eine oder die mehreren Abgriffe (306A, 306B, 308A, 308B) die durchgehende Rückwand (206, 206A, 206B) elektrisch mit dem negativen Anschluss (708) der Schaltungskarte (610) koppelt bzw. koppeln.

6. Photovoltaiksystem (100) nach Anspruch 2, wobei jedes der mehreren Photovoltaikmodule (102, 200) ferner eine optische Signalquelle (728) beinhaltet, die kommunikativ mit der digitalen Steuerung (704) gekoppelt ist und so an der Schaltungskarte (610) befestigt ist, dass die durch die optische Signalquelle (728) emittierten optischen Signale von einer Vorderseite des entsprechenden Photovoltaikmoduls (102, 200) sichtbar sind.

7. Photovoltaiksystem (100) nach Anspruch 2, wobei jedes der mehreren Photovoltaikmodule (102, 200) ferner eine Hochfrequenz (HF) emittierende Einrichtung (720) umfasst, die kommunikativ mit der digitalen Steuerung (704) gekoppelt ist, wobei die digitale Steuerung (704) dazu konfiguriert ist, die HF emittierende Einrichtung (720) zum Übermitteln von Informationen zu anderen der mehreren Photovoltaikmodule (102, 200) und/oder zu einer Datenerfassungseinrichtung, die im Photovoltaiksystem (100) enthalten ist, zu betreiben.

8. Photovoltaiksystem (100) nach Anspruch 2, wobei jedes der mehreren Photovoltaikmodule (102, 200) ferner eine Unterbaubaugruppe (210) umfasst, in der die Schaltungskarte (610) angeordnet ist, wobei die Unterbaubaugruppe (210) ein Gehäuse (602) beinhaltet, das Folgendes umfasst:
einen Hauptkörper (618) und
mehrere Füße (620A-620C), die sich vom Hauptkörper (618) erstrecken, wobei die mehreren Füße (620A-620C) im Wesentlichen koplanar sind,
wobei:
die Unterbaubaugruppe (210) mechanisch mit der durchgehenden Rückwand (206, 206A, 206B) des entsprechenden Photovoltaikmoduls (102, 200) unter Verwendung eines Klebstoffs oder eines Klebebands (626), der bzw. das zwischen der durchgehenden Rückwand (206, 206A, 206B) und den mehreren Füßen (620A-620C) angeordnet ist, gekoppelt ist; und
der Hauptkörper (618) zwei Schlitze (622A, 622B) definiert, durch die zwei entsprechende Steiger (606A, 606B) durch den Hauptkörper (618) laufen, um elektrisch mit der Schaltungskarte (610) gekoppelt zu werden.

9. Photovoltaiksystem (100) nach Anspruch 1, wobei jeder der mehreren Umsetzer (702) mit einem Tastverhältnis D in einem Bereich von [(V_out - V_in) / V_out - 0,05] < D < 0,75 betrieben wird, wobei V_out und V_in eine Ausgangsspannung und eine Eingangsspannung des entsprechenden Umsetzers (702) sind.

10. Photovoltaiksystem (100) nach Anspruch 1, wobei jedes der mehreren Photovoltaikmodule (102, 200) ferner Folgendes umfasst:
Messschaltkreise (714), die dazu konfiguriert sind, einen Ausgangsstrom zum Modul-Modul-Bus (104) oder einen Eingangsstrom vom Modul-Modul-Bus (104) zu messen; und
eine digitale Steuerung (704), die basierend auf der Messung dazu konfiguriert ist, einen Offset zwischen dem Ausgangsstrom und dem Eingangsstrom zu überwachen und/oder den Ausgangsstrom zu begrenzen, wenn der Ausgangsstrom eine voreingestellte Grenze überschreitet.

11. Photovoltaiksystem (100) nach Anspruch 1, ferner umfassend:
mehrere Wechselrichter (106), die elektrisch mit dem Modul-Modul-Bus (104) gekoppelt sind, so dass Energie, die durch jedes Photovoltaikmodul (102, 200) erzeugt wird, an einem beliebigen der mehreren Wechselrichter (106) empfangen werden kann.

12. Photovoltaiksystem (100) nach Anspruch 11, wobei eine oder mehrere Energiespeichereinrichtungen (108) parallel mit dem Modul-Modul-Bus (104) gekoppelt sind.

13. Photovoltaiksystem (100) nach Anspruch 12, wobei, basierend auf einem Gleichstromsollwert und einer Wechselstrombeschränkung von jedem der mehreren Wechselrichter (106) und basierend auf einem gegenwärtigen Ladezustand der einen oder der mehreren Energiespeichereinrichtungen (108), ein Strom folgendermaßen durch den Modul-Modul-Bus (104) und einen oder mehrere der mehreren Wechselrichter (106) fließt:
in die eine oder die mehreren Energiespeichereinrichtungen (108) von einer beliebigen oder allen Phasen eines Mehrphasen-Wechselstrom-Energieversorgungsnetzes (118), mit dem jeder der mehreren Wechselrichter (106) gekoppelt ist; oder
von der einen oder den mehreren Energiespeichereinrichtungen (108) in eine beliebige oder alle Phasen des Mehrphasen-Wechselstrom-Energieversorgungsnetzes (118).

14. Photovoltaiksystem (100) nach Anspruch 11, wobei jeder der mehreren Wechselrichter (106) dazu konfiguriert ist, ferner mit einer beliebigen oder allen drei Phasen eines Dreiphasen-Wechselstrom-Energieversorgungsnetzes (118) gekoppelt zu werden.

15. Photovoltaiksystem (100) nach Anspruch 11, wobei:
die mehreren Wechselrichter (106) drei Wechselrichter (106) umfassen;
jeder der drei Wechselrichter (106) ferner unter Verwendung einer Stern- oder Dreieckschaltung mit einer unterschiedlichen Phase eines Dreiphasen-Wechselstrom-Energieversorgungsnetzes (118) gekoppelt ist; und
jeder der drei Wechselrichter (106) einen unterschiedlichen Gleichstromsollwert aufweist, so dass ein Strom während des Betriebs folgendermaßen fließt:
von einer oder mehreren Phasen des Dreiphasen-Wechselstrom-Energieversorgungsnetzes (118) durch einen oder mehrere der mehreren Wechselrichter (106) mit einem relativ hohen Gleichstromsollwert zum Modul-Modul-Bus (104); und
vom Modul-Modul-Bus (104) durch einen oder mehrere der mehreren Wechselrichter (106) mit einem relativ niedrigen Gleichstromsollwert zu einer oder mehreren anderen Phasen des Dreiphasen-Wechselstrom-Energieversorgungsnetzes (118).

## Revendications

1. Système photovoltaïque (100) comprenant :
une pluralité de modules photovoltaïques (102, 200), chaque module photovoltaïque (102, 200) définissant une première extrémité (110, 202) et une seconde extrémité (112, 204) opposée à la première extrémité (110, 202), dans lequel chaque module photovoltaïque (102, 200) comprend :
une pluralité de cellules photovoltaïques (114, 404), dans lequel une énergie générée par chaque cellule photovoltaïque (114, 404) a des chemins multiples à travers la pluralité de cellules photovoltaïques (114, 404) jusqu'à la seconde extrémité (112, 204) ; et
une pluralité de convertisseurs (702) couplée électriquement à la pluralité de cellules photovoltaïques (114, 404) au niveau de la seconde extrémité (112, 204) de sorte qu'une énergie générée par chaque cellule photovoltaïque (114, 404) soit recevable au niveau de l'un quelconque de la pluralité de convertisseurs (702) ;
une couche arrière continue (206, 206A, 206B), la couche arrière continue (206, 206A, 206B) comprenant un plan de masse pour la pluralité de cellules photovoltaïques (114, 404) ;
dans lequel la couche arrière continue (206, 206A, 206B) est couplée électriquement entre un premier sous-ensemble (416) de la pluralité de cellules photovoltaïques (114, 404) au niveau de la première extrémité (110, 202) et un second sous-ensemble (506) de la pluralité de cellules photovoltaïques (114, 404) au niveau de la seconde extrémité (112, 204), dans lequel la couche arrière continue (206, 206A, 206B) est configurée pour porter un courant de retour de module depuis la seconde extrémité (112, 204) jusqu'à la première extrémité (110, 202) ;
une première connexion d'extrémité (418, 412A) entre la couche arrière continue (206, 206A, 206B) et le premier sous-ensemble (416) de la pluralité de cellules photovoltaïques (114, 404) au niveau de la première extrémité (110, 202) ;
une seconde connexion d'extrémité (412B, 508) entre la pluralité de convertisseurs (702) et le second sous-ensemble (506) de la pluralité de cellules photovoltaïques (114, 404) au niveau de la seconde extrémité (112, 204) ;
une carte de circuit imprimé (610) couplée mécaniquement à la seconde extrémité (112, 204), la carte de circuit imprimé (610) comportant la pluralité de convertisseurs (702) disposée sur celle-ci et comportant en outre un connecteur positif (706) et un connecteur négatif (708) ;
une barre omnibus interne (508) s'étendant selon une largeur du module photovoltaïque (102, 200), dans lequel la barre omnibus interne (508) est couplée à chacune des cellules photovoltaïques (114, 404) dans le second sous-ensemble (506) de la pluralité de cellules photovoltaïques (114, 404) ; et
un bus module à module (104) couplé électriquement à chacun de la pluralité de modules photovoltaïques (102, 200), le bus module à module (104) ayant une sortie, dans lequel une énergie générée par chaque module photovoltaïque (102, 200) est recevable au niveau de la sortie indépendamment d'un quelconque autre de la pluralité de modules photovoltaïques (102, 200),
dans lequel une ou plusieurs languettes (306A, 306B, 308A, 308B) s'étendent depuis la couche arrière continue (206, 206A, 206B) jusqu'à l'un des connecteurs (706, 708) de la carte de circuit imprimé (610), la ou les languettes (306A, 306B, 308A, 308B) couplant électriquement la couche arrière continue (206, 206A, 206B) à ce connecteur parmi les connecteurs (706, 708) de la carte de circuit imprimé (610),
**caractérisé en ce que**
la barre omnibus interne (508) comporte une languette (508A) s'étendant depuis la barre omnibus interne (508) à travers une fente (304) ou une découpe (310) formée dans la couche arrière continue (206, 206A, 206B) jusqu'à l'autre des connecteurs (706, 708) de la carte de circuit imprimé (610), la languette (508A) couplant électriquement la barre omnibus interne (508) à ce connecteur parmi les connecteurs (706, 708) de la carte de circuit imprimé (610).

2. Système photovoltaïque (100) selon la revendication 1, dans lequel chacun de la pluralité de modules photovoltaïques (102, 200) comprend en outre :
un dispositif de commande numérique (704) disposé sur la carte de circuit imprimé (610) ;
dans lequel la pluralité de convertisseurs (702) sont chacun commandés indépendamment des autres par le dispositif de commande numérique (704) via des lignes de modulation d'impulsions en largeur (PWM) et de validation appariées (724) depuis le dispositif de commande numérique (704) jusqu'à chacun de la pluralité de convertisseurs (702) ; et
le dispositif de commande numérique (704) de chacun des modules photovoltaïques (102, 200) est configuré pour :
faire circuler un courant de charge d'entretien sur le bus module à module (104) lorsqu'une tension sur le bus module à module (104) est inférieure à un seuil minimal (806) pour déterminer si un élément capacitif est fixé au bus module à module (104) ;
en réponse à la détermination qu'un élément capacitif est fixé au bus module à module (104), continuer à faire circuler un courant de charge d'entretien sur le bus module à module (104) jusqu'à ce que la tension sur le bus module à module (104) s'élève au-dessus du seuil minimal (806) ;
fermer un relais de protection (716) lorsque la tension sur le bus module à module (104) s'élève au-dessus du seuil minimal (806) pour garantir une commutation de courant nul, le relais de protection (716) étant couplé électriquement entre le bus module à module (104) et un bus de sortie (726) de la carte de circuit imprimé (610), le bus de sortie (726) étant couplé électriquement à des sorties (914) de chacun de la pluralité de convertisseurs (702) ;
exploiter la pluralité de convertisseurs (702) dans un mode de courant maximal lorsque la tension sur le bus module à module (104) est entre le seuil minimal (806) et un seuil intermédiaire (808) supérieur au seuil minimal (806) ;
exploiter la pluralité de convertisseurs (702) dans un mode de tension constante lorsque la tension sur le bus module à module (104) est entre le seuil intermédiaire (808) et un seuil maximal (804) supérieur au seuil minimal (806) ; et
ouvrir le relais de protection (716) lorsque la tension sur le bus module à module (104) s'élève au-dessus du seuil maximal (804) ou chute en dessous du seuil minimal (806).

3. Système photovoltaïque (100) selon la revendication 1, dans lequel :
la pluralité de cellules photovoltaïques (114, 404) est agencée en une pluralité de rangées (416, 506) couplées électriquement en série ;
chacun de la pluralité de modules photovoltaïques (102, 200) comprend en outre une pluralité de barres de rangée conductrices (414) couplant électriquement les cellules photovoltaïques (114, 404) dans chaque rangée (416, 506) les unes aux autres en parallèle ; et
les multiples chemins à travers la pluralité de cellules photovoltaïques (114, 404) jusqu'à la seconde extrémité (112, 204) comportent la pluralité de barres de rangée conductrices (414) de sorte qu'un courant généré puisse circuler, via la pluralité de barres de rangée conductrices (414), autour de cellules photovoltaïques (114, 404) avec une faible performance et/ou une faible illumination et à travers des cellules photovoltaïques (114, 404) avec une performance relativement plus élevée et/ou une illumination plus élevée jusqu'à la seconde extrémité (112, 204).

4. Système photovoltaïque (100) selon la revendication 1, dans lequel :
la première connexion d'extrémité (418, 412A) entre la couche arrière continue (206, 206A, 206B) et le premier sous-ensemble (416) de la pluralité de cellules photovoltaïques (114, 404) au niveau de la première extrémité (110, 202) comprend une anode du module photovoltaïque (102, 200) ;
la seconde connexion d'extrémité (412B, 508) entre la pluralité de convertisseurs (702) et le second sous-ensemble (506) de la pluralité de cellules photovoltaïques (114, 404) au niveau de la seconde extrémité (112, 204) comprend une cathode du module photovoltaïque (102, 200) ; et
la couche arrière continue (206, 206A, 206B) est configurée pour porter un courant de retour de module depuis la cathode jusqu'à l'anode.

5. Système photovoltaïque (100) selon la revendication 4, dans lequel
la barre omnibus interne (508) est couplée à une cathode de chacune des cellules photovoltaïques (114, 404) dans le second sous-ensemble (506) de la pluralité de cellules photovoltaïques (114, 404) ; et
la languette (508A) de la barre omnibus interne (508) couple électriquement la barre omnibus interne (508) au connecteur positif (706) de la carte de circuit imprimé (610) ; et
dans lequel les une ou plusieurs languettes (306A, 306B, 308A, 308B) s'étendent depuis la couche arrière continue (206, 206A, 206B) jusqu'au connecteur négatif (708) de la carte de circuit imprimé (610), les une ou plusieurs languettes (306A, 306B, 308A, 308B) couplant électriquement la couche arrière continue (206, 206A, 206B) au connecteur négatif (708) de la carte de circuit imprimé (610).

6. Système photovoltaïque (100) selon la revendication 2, dans lequel chacun de la pluralité de modules photovoltaïques (102, 200) comporte en outre une source de signaux optiques (728) couplée avec faculté de communication au dispositif de commande numérique (704) et montée sur la carte de circuit imprimé (610) de sorte que des signaux optiques émis par la source de signaux optiques (728) soient visibles depuis une partie avant du module photovoltaïque (102, 200) correspondant.

7. Système photovoltaïque (100) selon la revendication 2, dans lequel chacun de la pluralité de modules photovoltaïques (102, 200) comprend en outre un dispositif d'émission de radiofréquence (RF) (720) couplé avec faculté de communication au dispositif de commande numérique (704), le dispositif de commande numérique (704) étant configuré pour exploiter le dispositif d'émission RF (720) pour transmettre des informations à d'autres de la pluralité de modules photovoltaïques (102, 200) et/ou à un dispositif de collecte de données inclus dans le système photovoltaïque (100).

8. Système photovoltaïque (100) selon la revendication 2, dans lequel chacun de la pluralité de modules photovoltaïques (102, 200) comprend en outre un ensemble encastré (210) au sein duquel la carte de circuit imprimé (610) est disposée, l'ensemble encastré (210) comportant un logement (602) comprenant :
un corps principal (618) ; et
une pluralité de pieds (620A à 620C) s'étendant depuis le corps principal (618), la pluralité de pieds (620A à 620C) étant sensiblement coplanaire,
dans lequel :
l'ensemble encastré (210) est couplé mécaniquement à la couche arrière continue (206, 206A, 206B) du module photovoltaïque (102, 200) correspondant à l'aide d'un adhésif ou d'une bande (626) disposé entre la couche arrière continue (206, 206A, 206B) et la pluralité de pieds (620A à 620C) ; et
le corps principal (618) définit deux fentes (622A, 622B) à travers lesquelles deux ailettes de connexion (606A, 606B) correspondantes passent à travers le corps principal (618) pour se coupler électriquement à la carte de circuit imprimé (610).

9. Système photovoltaïque (100) selon la revendication 1, dans lequel chacun de la pluralité de convertisseurs (702) est exploité avec un cycle de service D dans une plage de [(V_out - V_in)/V_out - 0,05] < D < 0,75, où V_out et V_in sont une tension de sortie et une tension d'entrée du convertisseur (702) correspondant.

10. Système photovoltaïque (100) selon la revendication 1, dans lequel chacun de la pluralité de modules photovoltaïques (102, 200) comprend en outre :
une circuiterie de mesure (714) configurée pour mesurer un courant de sortie jusqu'au bus module à module (104) ou un courant d'entrée depuis le bus module à module (104) ; et
un dispositif de commande numérique (704) configuré, d'après la mesure, pour surveiller un décalage entre le courant de sortie et le courant d'entrée et/ou pour limiter le courant de sortie lorsque le courant de sortie dépasse une limite préétablie.

11. Système photovoltaïque (100) selon la revendication 1, comprenant en outre :
une pluralité d'onduleurs (106) couplée électriquement au bus module à module (104) de sorte qu'une énergie générée par chaque module photovoltaïque (102, 200) soit recevable au niveau de l'un quelconque de la pluralité d'onduleurs (106).

12. Système photovoltaïque (100) selon la revendication 11, dans lequel un ou plusieurs dispositifs de stockage d'énergie (108) sont couplés en parallèle au bus module à module (104).

13. Système photovoltaïque (100) selon la revendication 12, dans lequel d'après un point de consigne de courant continu et une réduction de consommation de courant alternatif de chacun de la pluralité d'onduleurs (106) et un état de courant de charge des un ou plusieurs dispositifs de stockage d'énergie (108), le courant circule à travers le bus module à module (104) et un ou plusieurs de la pluralité d'onduleurs (106) :
dans le ou les dispositifs de stockage d'énergie (108) depuis l'une quelconque des ou toutes les phases d'un réseau électrique de courant alternatif multiphase (118) auquel chacun de la pluralité d'onduleurs (106) est couplé ; ou
depuis le ou les dispositifs de stockage d'énergie (108) dans l'une quelconque des ou toutes les phases d'un réseau électrique de courant alternatif multiphase (118).

14. Système photovoltaïque (100) selon la revendication 11, dans lequel chacun de la pluralité d'onduleurs (106) est configuré pour être couplé en outre à l'une quelconque ou aux trois phases d'un réseau électrique de courant alternatif triphasé (118).

15. Système photovoltaïque (100) selon la revendication 11, dans lequel :
la pluralité d'onduleurs (106) comprend trois onduleurs (106) ;
chacun des trois onduleurs (106) est en outre couplé à une phase différente d'un réseau électrique de courant alternatif triphasé (118) à l'aide d'une connexion en Y ou en triangle ; et
chacun des trois onduleurs (106) a un point de consigne de courant continu différent de sorte qu'en fonctionnement, le courant circule :
depuis une ou plusieurs phases du réseau électrique de courant alternatif triphasé (118) à travers un ou plusieurs de la pluralité d'onduleurs (106) avec un point de consigne de courant continu relativement élevé jusqu'au bus module à module (104) ; et
depuis le bus module à module (104) à travers un ou plusieurs de la pluralité d'onduleurs (106) avec un point de consigne de courant continu relativement faible jusqu'à une ou plusieurs autres phases du réseau électrique de courant alternatif triphasé (118).
